# EUROPÄISCHE PATENTSCHRIFT

(11) **EP 2 837 030 B1**
(45) Veröffentlichungstag und Bekanntmachung des Hinweises auf die Patenterteilung: **13.06.2018**
(21) Anmeldenummer: 13714614.8
(22) Anmeldetag: 28.03.2013
(51) Int. Cl.: H01L 27/142, H01L 31/0392, H01L 31/0749, H01L 31/032

(54) **PHOTOVOLTAISCHE DÜNNSCHICHTSOLARMODULE SOWIE VERFAHREN ZUR HERSTELLUNG SOLCHER DÜNNSCHICHTSOLARMODULE**
PHOTOVOLTAIC THIN-FILM SOLAR MODULES AND METHOD FOR PRODUCING SUCH THIN-FILM SOLAR MODULES
MODULES SOLAIRES EN COUCHES MINCES PHOTOVOLTAÏQUES ET PROCÉDÉ DE FABRICATION DE TELS MODULES SOLAIRES EN COUCHES MINCES

(30) Priorität: 12.04.2012 DE 102012205978
(43) Veröffentlichungstag der Anmeldung: 18.02.2015
(73) Patentinhaber: Probst, Volker, 14089 Berlin (DE)
(72) Erfinder: Probst, Volker, 14089 Berlin (DE)
(86) Internationale Anmeldenummer: PCT/EP2013/056767
(87) Internationale Veröffentlichungsnummer: WO 2013/152965

(56) Entgegenhaltungen:
- EP-A1- 1 710 844
- EP-A1- 2 284 892
- WO-A2-2011/032717
- DE-C1- 4 442 824
- GB-A- 2 483 922
- US-A1- 2010 015 752
- US-A1- 2011 240 118
- PATRICK BLÖSCH ET AL: "Comparative Study of Different Back-Contact Designs for High-Efficiency CIGS Solar Cells on Stainless Steel Foils", IEEE JOURNAL OF PHOTOVOLTAICS, I E E E, US, Bd. 1, Nr. 2, 1. Oktober 2011 (2011-10-01) , Seiten 194-199, XP011390833, ISSN: 2156-3381, DOI: 10.1109/JPHOTOV.2011.2166589

## Beschreibung

Die vorliegende Erfindung betrifft photovoltaische Dünnschichtsolarmodule sowie ein Verfahren zur Herstellung solcher Dünnschichtsolarmodule. Die Dokumente GB 2 483922A und P. Blösch et al, IEEE journal of Photovoltiacs, IEEE, N. 2, 01.10.2011, Seiten 194-199, XP011390833 beschreiben Dünnschichtsolarzellen. Photovoltaische Solarmodule sind seit langem bekannt und auch im Handel erhältlich. Geeignete Solarmodule umfassen einerseits kristalline und amorphe Siliziumsolarmodule und andererseits sogenannte Dünnschichtsolarmodule. Derartige Dünnschichtsolarmodule basieren zum Beispiel auf der Verwendung einer sogenannten Chalkopyrit-Halbleiterabsorberschicht, beispielsweise einem Cu(In,Ga)(Se,S)-System, und stellen ein komplexes Mehrschichtsystem dar. Bei diesen Dünnschichtsolarmodulen liegt auf einem Glassubstrat üblicherweise eine Molybdänrückelektrodenschicht auf. Diese wird in einer Verfahrensvariante mit einer Kupfer und Indium sowie gegebenenfalls Gallium umfassenden Precursor-Metalldünnschicht versehen und anschließend in Gegenwart von Schwefelwasserstoff und/oder Selenwasserstoff bei erhöhten Temperaturen zu einem so genannten CIS- bzw. CIGS-System umgesetzt. In einer weiteren Verfahrensvariante können statt Selenwasserstoff und Schwefelwasserstoff auch elementarer Selendampf und Schwefeldampf eingesetzt werden. Die Herstellung solcher Dünnschichtsolarmodule ist folglich ein vielstufiger Prozess, bei dem aufgrund zahlreicher Wechselwirkungen jede Verfahrensstufe sorgsam auf nachfolgende Verfahrensstufen abgestimmt werden muss. Auch ist besondere Obacht bei der Auswahl und Reinheit der bei jeder Schicht zu verwendenden Materialien erforderlich. Anlagentechnisch bedingt ist es vielfach nicht oder nur sehr schwer möglich, Dünnschichtsolarmodule großtechnisch zu fertigen, deren Modulformat eine Größe von 1,2 m x 0,5 m überschreitet. Auch kann bislang bei den in einzelnen Herstellstufen anzuwendenden Temperaturen und Reaktionsbedingungen eine Kontamination oder Interdiffusion von Komponenten, Dotierstoffen oder Verunreinigungen einzelner Schichten des Mehrschichtsystems nicht ausgeschlossen werden. Schon mit der Wahl und der Art der Herstellung der Rückelektrodenschicht kann Einfluss auf den Wirkungsgrad einer Dünnschichtsolarzelle genommen werden. Beispielsweise hat die Rückelektrodenschicht über eine hohe Querleitfähigkeit zu verfügen, um eine verlustarme Serienverschaltung sicherzustellen. Auch sollten aus dem Substrat und/oder der Halbleiterabsorberschicht migrierende Substanzen keinen Einfluss auf die Qualität und Funktion der Rückelektrodenschicht oder der Halbleiterabsorberschicht haben. Darüber hinaus muss das Material der Rückelektrodenschicht eine gute Anpassung an das thermische Ausdehnungsverhalten von Substrat und den darüber liegenden Schichten aufweisen, um Mikrorisse zu vermeiden. Schließlich sollte auch die Haftung auf der Substratoberfläche allen gängigen Nutzungsanforderungen genügen. Zwar ist es möglich, zu guten Wirkungsgraden über den Einsatz von besonders reinem Rückelektrodenmaterial zu gelangen, allerdings gehen hiermit regelmäßig unverhältnismäßig hohe Produktionskosten einher. Zudem führen die vorangehend genannten Migrations- bzw. insbesondere Diffusionsphänome unter den üblichen Produktionsbedingungen nicht selten zu einer signifikanten Verunreinigung des Rückelektrodenmaterials. Zum Beispiel kann ein Dotierstoff, der in die Halbleiterabsorberschicht eingebracht ist, durch vorangehend genannte Diffusion in die Rückelektrode diffundieren und dadurch in der Halbleiterabsorberschicht verarmen. Die Konsequenz sind deutlich niedrigere Wirkungsgrade des fertiggestellten Solarmoduls. Man ist selbst bei Beachtung aller Verfahrens- und Materialoptimierungen noch stets stark eingeschränkt bei dem letztendlichen Design der für den Vertrieb vorgesehenen Dünnschichtsolarmodule.

Zu einer Solarzelle mit morphologisch gut ausgebildeter Absorberschicht und guten Wirkungsgraden soll man gemäß der DE 44 42 824 C1 dadurch gelangen, dass man die Chalkopyrit-Halbleiterabsorberschicht mit einem Element aus der Gruppe Natrium, Kalium und Lithium in einer Dosis von 10¹⁴ bis 10¹⁶ Atomen/cm² dotiert und gleichzeitig eine Diffusionssperrschicht zwischen dem Substrat und der Halbleiterabsorberschicht vorsieht. Alternativ wird vorgeschlagen, ein alkalifreies Substrat zu verwenden, sofern auf eine Diffusionssperrschicht verzichtet werden soll.

Blösch et al. (Thin Solid Films 2011) schlagen vor, bei Verwendung einer Polyimidsubstratfolie ein Schichtsystem aus Titan, Titannitrid und Molybdän zu verwenden, um gute Haftungseigenschaften und ein zufriedenstellendes thermisches Eigenschaftsprofil zu erhalten. Blösch et al. (IEEE, 2011, Vol. 1, Nr. 2, Seiten 194 bis 199) schlagen für die Verwendung flexibler Dünnschichtsolarzellen ferner den Einsatz einer Edelstahlsubstratfolie vor, auf welche zunächst zwecks Verbesserung der Haftung eine dünne Titanschicht aufgebracht wird. Zufriedenstellende Ergebnisse wurden mit solchen CIGS-Dünnschichtsolarzellen erzielt, welche mit einer Titan/Molybdän/Molybdän-Dreifachlage ausgestattet waren. Verbesserte Dünnschichtsolarzellen werden auch mit der technischen Lehre der WO 2011/123869 A2 angestrebt. Die darin offenbarte Solarzelle umfasst ein Natriumglassubstrat, eine Molybdän-Rückelektrodenschicht, eine CIGS-Schicht, eine Pufferschicht, eine Schicht aus intrinsischem Zinkoxid und eine Schicht aus mit Aluminium dotiertem Zinkoxid. Ein erster Trenngraben erstreckt sich über die Molybdänschicht, die CIGS-Schicht und die Pulverschicht, ein zweiter Trenngraben beginnt oberhalb der Molybdänschicht. Ein isolierendes Material wird in bzw. auf dem ersten Trenngraben abgeschieden, und eine Frontelektrodenschicht ist schräg auf die Solarzelle, einschließlich des ersten Trenngrabens, abzuscheiden. Auf diese Weise sollen Dünnschichtsolarzellen mit verbesserter Lichtausbeute erhalten werden. Die US 2004/014419 A1 ist bestrebt, eine Dünnschichtsolarzelle zur Verfügung zu stellen, deren Molybdän-Rückelektrodenschicht über einen verbesserten Wirkungsgrad verfügt. Dieses soll dadurch erreicht werden, dass man ein Glassubstrat mit einer Rückelektrodenschicht aus Molybdän versieht, deren Dicke 500 nm nicht überschreiten soll.

Dass unterschiedlichste Metalle wie Wolfram, Molybdän, Chrom, Tantal, Niob, Vanadium, Titan und Mangan als geeignete Rückelektrodenmaterialen für Dünnschichtsolarzellen in Frage kommen, ist schon bei Orgassa et al. (Thin Solid Films, 2003, Vol. 431-432, Seiten 1987 bis 1993) zu finden.

Es wäre daher wünschenswert, auf ein Verfahren zur Herstellung von photovoltaischen Dünnschichtsolarmodulen zurückgreifen zu können, das nicht mit den Nachteilen des Stands der Technik behaftet ist und das insbesondere mit weniger Prozessschritten auskommt und gleichwohl nicht Restriktionen, beispielsweise hinsichtlich Modulformaten, ausgesetzt ist, wie sie aus den Verfahren des Stands der Technik bekannt sind. Ferner lag der vorliegenden Erfindung die Aufgabe zugrunde, Dünnschichtsolarmodule zugänglich zu machen, die über einen größeren Füllfaktor und einen höheren Wirkungsgrad verfügen und weniger empfindlich gegenüber den Bedingungen des Herstellverfahrens sind und gleichwohl eine große Designvielfalt zulässt, z.B. hinsichtlich Länge, Breite und Form.

Demgemäß wurde ein photovoltaisches Dünnschichtsolarmodul (auch erste Ausgestaltung des erfindungsgemäßen Dünnschichtsolarmoduls genannt) gefunden, umfassend, insbesondere in dieser Reihenfolge,
mindestens eine Substratschicht, insbesondere eine Glasscheibe,
mindestens eine, insbesondere an der Substratschicht unmittelbar anliegende, Rückelektrodenschicht, insbesondere enthaltend oder im Wesentlichen aus Molybdän, mindestens eine, insbesondere an der Rückelektrodenschicht und/oder an der Substratschicht unmittelbar anliegende, leitfähige Barriereschicht, insbesondere bidirektionale Barriereschicht,
mindestens eine, insbesondere an der Barriereschicht unmittelbar anliegende, Kontaktschicht, insbesondere Ohm'sche Kontaktschicht, insbesondere enthaltend oder im Wesentlichen aus Molybän und/oder Molybdänselenid und/oder Molybdänsulfoselenid, mindestens eine, insbesondere an der Kontaktschicht unmittelbar anliegende, Halbleiterabsorberschicht, insbesondere Chalkopyrit- oder Kesterit-Halbleiterabsorberschicht,
gegebenenfalls mindestens eine, insbesondere an der Halbleiterabsorberschicht unmittelbar anliegende, erste Pufferschicht, enthaltend oder im Wesentlichen gebildet aus CdS oder einer CdS-freien Schicht, insbesondere enthaltend oder im Wesentlichen aus Zn(S,OH) oder In₂S₃, und/oder
gegebenenfalls mindestens eine, insbesondere an der Halbleiterabsorberschicht oder der ersten Pufferschicht unmittelbar anliegende, zweite Pufferschicht, enthaltend und im Wesentlichen gebildet aus intrinsischem Zinkoxid und/oder hochohmigem Zinkoxid, und mindestens eine, insbesondere an der Halbleiterabsorberschicht, der ersten Pufferschicht und/oder der zweiten Pufferschicht unmittelbar anliegende, transparente Frontelektrodenschicht, insbesondere enthaltend oder im Wesentlichen aus n-dotiertem Zinkoxid, gekennzeichnet durch
beabstandete erste, mit mindestens einem Isolatormaterial befüllte Strukturierungstrenngräben, welche benachbarte Solarzellen bis zur Substratschicht voneinander trennen,
beabstandete zweite, mit mindestens einem leitfähigen Material befüllte oder versehene Strukturierungstrenngräben, welche sich bis zur Kontaktschicht oder bis zur Rückelektrodenschicht oder bis zur Barriereschicht, insbesondere bis zur Barriereschicht, erstrecken und jeweils benachbart zu einem befüllten ersten Strukturierungstrenngraben vorliegen,
beabstandete dritte Strukturierungstrenngräben, welche sich bis zur Kontaktschicht oder bis zur Rückelektrodenschicht oder bis zur Barriereschicht, insbesondere bis zur Barriereschicht, erstrecken und jeweils benachbart zu einem zweiten Strukturierungsgraben, jenseits des ersten Strukturierungsgrabens, zu welchem der zweite Strukturierungstrenngraben benachbart ist, vorliegen, und
mindestens eine leitfähige Brücke von mit dem leitfähigen Material befüllten oder mit einem solchen Material versehenen zweiten Strukturierungstrenngräben über benachbarte erste, mit dem Isolatormaterial befüllte Strukturierungstrenngräben zu der Frontelektrodenschicht der hierzu benachbarten Solarzelle, so dass benachbarte Solarzellen elektrisch serienverschaltet werden.

Die der Erfindung zugrunde liegende Aufgabe wird des weiteren gelöst durch eine photovoltaisches Dünnschichtsolarmodul (auch zweite Ausgestaltung eines erfindungsgemäßen Dünnschichtsolarmoduls genannt), umfassend, insbesondere in dieser Reihenfolge,
mindestens eine Substratschicht, insbesondere eine Glasscheibe,
mindestens eine, insbesondere an der Substratschicht unmittelbar anliegende, Rückelektrodenschicht, insbesondere enthaltend oder aus Molybdän,
mindestens eine, insbesondere an der Rückelektrodenschicht unmittelbar anliegende, leitfähige Barriereschicht, insbesondere bidirektionale Barriereschicht,
mindestens eine, insbesondere an der Barriereschicht unmittelbar anliegende, Kontaktschicht, insbesondere Ohm'sche Kontaktschicht, insbesondere enthaltend oder aus Molybdän und/oder Molybdänselenid und/oder Molybdänsulfoselenid,
mindestens eine, insbesondere an der Kontaktschicht unmittelbar anliegende, Halbleiterabsorberschicht, insbesondere Chalkopyrit- oder Kesterit-Halbleiterabsorberschicht,
gegebenenfalls mindestens eine, insbesondere an der Halbleiterabsorberschicht unmittelbar anliegende, erste Pufferschicht, enthaltend oder im Wesentlichen gebildet aus CdS oder einer CdS-freien Schicht, insbesondere enthaltend oder im Wesentlichen aus Zn(S,OH) oder In₂S₃, und/oder
gegebenenfalls mindestens eine, insbesondere an der Halbleiterabsorberschicht oder der ersten Pufferschicht unmittelbar anliegende, zweite Pufferschicht, enthaltend und im Wesentlichen gebildet aus intrinsischem Zinkoxid und/oder hochohmigem Zinkoxid,
und mindestens eine, insbesondere an der Halbleiterabsorberschicht, der ersten Pufferschicht und/oder der zweiten Pufferschicht unmittelbar anliegende, transparente Frontelektrodenschicht, insbesondere enthaltend oder im Wesentlichen gebildet aus n-dotiertem Zinkoxid, gekennzeichnet durch
beabstandete erste, mit mindestens einem Isolatormaterial befüllte Strukturierungstrenngräben, welche benachbarte Solarzellen bis zur Substratschicht voneinander trennen,
beabstandete vierte Strukturierungstrenngräben, die sich bis zur Kontaktschicht oder bis zur Rückelektrodenschicht oder bis zur Barriereschicht, insbesondere bis zur Barriereschicht, erstrecken und jeweils benachbart zu einem befüllten ersten Strukturierungstrenngraben vorliegen und die einen ersten Volumenbereich, der sich von der Barriereschicht bis zur Frontelektrodenschicht entlang der zum ersten Strukturierungstrenngraben benachbarten Trenngrabenwand erstreckt und der mit mindestens einem leitfähigen Material ausgefüllt oder versehen ist, und einen hierzu benachbarten zweiten Volumenbereich, der sich von der Kontaktschicht oder bis zur Rückelektrodenschicht oder bis zur Barriereschicht, insbesondere bis zur Barriereschicht, bis zur Frontelektrodenschicht erstreckt, umfassen, und
mindestens eine leitfähige Brücke von den mit einem leitfähigen Material ausgefüllten oder mit einem solchen Material versehenen ersten Volumenbereichen der zweiten Strukturierungstrenngräben über benachbarte erste, mit einem Isolatormaterial befüllte Strukturierungstrenngräben zu der Frontelektrodenschicht der hierzu benachbarten Solarzelle, so dass benachbarte Solarzellen elektrisch serienverschaltet werden.

Bei diesen ersten und zweiten Ausgestaltungen erfindungsgemäßer photovoltaischer Dünnschichtsolarmodule können in einer ersten Ausführungsform auf der Substratschicht zunächst eine erste leitfähige Barriereschicht, hierauf die Rückelektrodenschicht, hierauf die Kontaktschicht, hierauf die Halbleiterabsorberschicht, hierauf gegebenenfalls die erste oder zweite Pufferschicht, und hierauf die Frontelektrodenschicht vorliegen. Bei diesen ersten und zweiten Ausgestaltungen können ferner in einer zweiten Ausführungsform auf der Substratschicht zunächst eine erste leitfähige Barriereschicht, hierauf die Rückelektrodenschicht, hierauf die zweite leitfähige Barriereschicht, hierauf die Kontaktschicht, hierauf die Halbleiterabsorberschicht, hierauf gegebenenfalls die erste oder zweite Pufferschicht, und hierauf die Frontelektrodenschicht vorliegen. Des weiteren können bei der ersten und zweiten Ausgestaltung erfindungsgemäßer Dünnschichtsolarmodule in einer dritten Ausführungsform, welche bevorzugt ist, auf der Substratschicht zunächst die Rückelektrodenschicht, hierauf die leitfähige Barriereschicht, hierauf die Kontaktschicht hierauf die Halbleiterabsorberschicht, hierauf gegebenenfalls die erste oder zweite Pufferschicht, und hierauf die Frontelektrodenschicht vorliegen.

Dabei kann in einer Ausführungsform vorgesehen sein, dass die Halbleiterabsorberschicht eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,Sₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellt oder umfasst, wobei x beliebige Werte von 0 bis 1 annimmt.

Das Substrat stellt vorzugsweise eine Platte oder Folie dar. Das Substrat kann z.B. Glassubstrat wie eine Glasscheibe, eine flexible oder nicht-flexible Kunststoffschicht, beispielsweise Kunststofffolien, oder eine Metallplatte, beispielsweise Edelstahlschichten bzw. -folien insbesondere, mit einer Breite größer 0,5 m, insbesondere größer 2,0 m, und einer Länge größer 1,2 m, insbesondere größer 3,0 m, darstellen. Beispielsweise ist es sogar möglich, Substratformate, insbesondere Substratglasformate, mit einer Breite von 3,2 m und einer Länge von 6 m zu verwenden. Hieraus lassen sich z.B. 16 Dünnschichtsolarmodule im Modulformat 1,6 m x 0,7 m erhalten.

In einer besonders geeigneten Ausgestaltung ist vorgesehen, dass Rückelektrodenschicht enthält oder im Wesentlichen gebildet ist aus V, Mn, Cr, Mo, Ti, Co, Zr, Ta, Nb und/oder W und/oder enthält oder im Wesentlichen gebildet ist aus einer Legierung enthaltend V, Mn, Cr, Mo, Ti, Co, Fe, Ni, Al, Zr, Ta, Nb und/oder W. Die Rückelektrode im Sinne der vorliegenden Erfindung kann auch als Bulk-Rückelektrode und das System aus Bulk-Rückelektrode bzw. Rückelektrode, Barriereschicht und Kontaktschicht als Mehrschicht-Rückelektrode bezeichnet werden.

Dabei kann auch vorgesehen sein, dass die Barriereschicht eine Barriere für aus der und/oder über die Rückelektrodenschicht migrierende, insbesondere diffundierende bzw. diffundierbare, Komponenten, insbesondere Dotierstoffe, und/oder für aus der und/oder über die Kontaktschicht migrierende, insbesondere diffundierende bzw. diffundierbare, Komponenten, insbesondere Dotierstoffe, insbesondere eine bidirektionale Barriereschicht, darstellt. In letzterem Fall verhindert die Barriereschicht die Abreicherung der Halbleiterschicht an einem der diese Schicht bildenden Dotierstoff, z. B. Natrium, wodurch ein unbeeinträchtigter Wirkungsgrad beibehalten werden kann.

Die Barriereschicht ist zweckmäßiger Weise eine Barriere für Alkaliionen, insbesondere Natriumionen, oder Verbindungen enthaltend Alkaliionen, Selen oder Selenverbindungen, Schwefel oder Schwefelverbindungen und/oder Metalle, insbesondere Cu, In, Ga, Fe, Ni, Ti, Zr, Hf, V, Nb, Ta, Al und/oder W. Sie ist vorzugsweise eine bidirektionale Barriereschicht und verhindert eine Kontamination der Halbleiterabsorberschicht mit Komponenten aus der Substrat- und/oder der Rückelektrodenschicht wie auch eine Kontamination der Rückelektrodenschicht mit Komponenten der Halbleiterschicht wie Cu, In und Ga. In letzterem Fall verhindert die Barriereschicht die Abreicherung der Halbleiterschicht an einem der diese Schicht bildenden Metalle, wodurch ein unbeeinträchtigter Wirkungsgrad beibehalten werden kann.

Die Barriereschicht der erfindungsgemäßen Rückelektrode verfügt in einer besonders zweckmäßigen Ausgestaltung über Barriereeigenschaften, insbesondere bidirektionale Barriereeigenschaften, gegenüber Dotierstoffen, insbesondere gegenüber Dotierstoffen für die Halbleiterabsorberschicht und/oder aus der Halbleiterabsorberschicht, gegenüber Chalkogenen wie Selen und/oder Schwefel sowie Chalkogenverbindungen, gegenüber den metallischen Bestandteilen der Halbleiterabsorberschicht wie Cu, In, Ga, Sn und/oder Zn, gegenüber Verunreinigungen wie Eisen und/oder Nickel aus der Rückelektrodenschicht und/oder gegenüber Komponenten und/oder Verunreinigungen aus dem Substrat. Die bidirektionalen Barriereeigenschaften gegenüber Dotierstoffen aus dem Substrat sollen zum einen eine Anreicherung an der Grenzfläche der Rückelektrode bzw. Kontaktschicht zur Halbleiterabsorberschicht mit Alkaliionen, z.B. ausdiffundierend aus einem Glassubstrat, verhindern. Solche Anreicherungen sind bekannt als Grund für Halbleiter-Schichtablösungen. Die leitfähige Barrierenschicht soll damit Haftungsprobleme vermeiden helfen. Andererseits soll die Barriereeigenschaft für Dotierstoffe, ausdiffundierbar bzw. ausdiffundierend aus dem Halbleiterabsorber, verhindern, dass Dotierstoff auf diese Weise an die Rückelektrode verlorengeht und damit der Halbleiterabsorber an Dotierstoff verarmt, was den Wirkungsgrad der Solarzelle oder des Solarmoduls deutlich reduzieren würde. Denn es ist beispielsweise bekannt, dass Molybdän-Rückelektroden signifikante Mengen an Natrium-Dotierstoff aufnehmen können. Die bidirektionale leitfähige Barriereschicht soll somit die Voraussetzungen für eine gezielte Dosierung von Dotierstoff in die Halbleiterabsorberschicht ermöglichen, um reproduzierbar hohe Wirkungsgrade der Solarzellen und -Modulen erreichen zu können.

Die Barriereeigenschaft gegenüber Chalkogenen soll demgemäß verhindern, dass diese an die Rückelektrode gelangen und dort Metallchalkogenidverbindungen ausbilden. Bekanntlich tragen diese Chalkogenidverbindungen, z.B. MoSe, zu einer erheblichen Volumenvergrößerung der oberflächennahen Schicht der Rückelektrode bei, was wiederum Unebenheiten in der Schichtenstruktur und verschlechterte Haftung mit sich bringt. Verunreinigungen des Rückelektrodenmaterials wie Fe und Ni stellen sogenannte tiefe Störstellen für z.B. Chalkopyrit-Halbleiter (Halbleitergifte) dar und sind demzufolge über die Barriereschicht von der Halbleiterabsorberschicht fernzuhalten.

In einer zweckmäßigen Ausgestaltung weist die Barriereschicht üblicherweise eine durchschnittliche Dicke von mindestens 10 nm, insbesondere mindestens 30 nm und vorzugsweise von maximal 250 nm oder 150 nm, auf.

Bedingt durch den Umstand des Vorliegens einer Barriereschicht ist es z.B. möglich, den Reinheitsgrad des Rückelektrodenmaterials signifikant zu reduzieren. Beispielsweise kann die Rückelektrodenschicht verunreinigt sein mit mindestens einem Element ausgewählt aus der Gruppe bestehend aus Fe, Ni, Al, Cr, Ti, Zr, Hf, V, Nb, Ta, W und/oder Na und/oder mit Verbindungen der genannten Elemente, ohne dass der Wirkungsgrad der die erfindungsgemäße Rückelektrode aufweisenden Dünnschichtsolarzelle bzw. des -moduls nachhaltig beeinträchtigt wird.

Besonders bevorzugt sind Barriereschichten enthaltend oder im Wesentlichen aus mindestens einem Metallnitrid, insbesondere TiN, MoN, TaN, ZrN und/oder WN, mindestens einem Metallcarbid, mindestens einem Metallborid und/oder mindestens einem Metallsiliziumnitrid, insbesondere TiSiN, TaSiN und/oder WSiN. Hierbei wird besonders auf solche Barriereschichten zurückgegriffen, beispielsweise TiN, die eine das Licht reflektierende Oberfläche liefern. Auf diese Weise kann Licht, das die Halbleiterabsorberschicht passiert hat, zur Steigerung des Wirkungsgrads nochmals durch diese gelenkt werden.

Derartige Metallnitride sind bevorzugt als Barrierematerialien im Sinne der vorliegenden Erfindung, beispielsweise TiN, bei denen das Metall hinsichtlich Stickstoff stöchiometrisch oder überstöchiometrisch, also mit Stickstoff im Überschuss, abgeschieden wird. In einer weiteren Ausführungsform ist vorgesehen, dass man vor, während und/oder nach der Abscheidung der Barriereschicht, insbesondere einer Metallnitrid- oder Metallsiliziumnitridbarriereschicht Sauerstoff in dieser Verfahrensstufe, insbesondere in geringen Mengen, zudosiert. Hierdurch sollen die Barriereeigenschaften erhöht werden, ohne gleichzeitig die Leitfähigkeit der Barriere signifikant zu erniedrigen. Die Zudosierung von Sauerstoff im Zusammenhang mit der Aufbringung der Barriereschicht soll dazu führen, dass die Korngrenzen der nicht selten polykristallinen Dünnschichtbarriere mit Sauerstoff bzw. Sauerstoffverbindungen blockiert werden.

Ein weiterer Vorteil des Einsatzes einer Barriereschicht als Bestandteil eines Mehrschicht-Rückelektrodensystems (aus Rückelektroden-, Barriere- und Kontaktschicht) manifestiert sich bei Verwendung in erfindungsgemäßen Dünnschichtsolarmodulen auch darin, dass die Dicke der Halbleiterabsorberschicht, beispielsweise der Chalkopyrit- oder Kesterit-Schicht, gegenüber herkömmlichen Systemen merklich verringert werden kann. Denn durch die Barriereschicht, insbesondere wenn in Form von Metallnitriden, beispielsweise Titannitrid, oder enthaltend solche Metall- bzw. Titannitride vorliegend, wird das die Halbleiterabsorberschicht passierende Sonnenlicht sehr effektiv reflektiert, so dass sich im Wege des Doppeldurchtritts durch die Halbleiterabsorberschicht eine sehr gute Quantenausbeute erzielen lässt. Durch die Anwesenheit der genannten Barriereschicht in der erfindungsgemäßen Rückelektrode bzw. in Dünnschichtsolarzellen bzw. -modulen, enthaltend diese Rückelektrode kann die durchschnittliche Dicke der Halbleiterabsorberschicht auf z. B. Werte im Bereich von 0,4 µm bis 1,5 µm, beispielsweise auf Werte im Bereich von 0,5 µm bis 1,2 µm, verringert werden.

Die Barriereschicht liegt vorzugsweise zwischen der Rückelektrodenschicht und der Kontaktschicht vor. Alternativ oder zusätzlich kann mindestens eine Barriereschicht, wie vorangehend beschrieben, auch zwischen der Substratschicht und der Rückelektrodenschicht angebracht sein. In einem solchen Fall liegt die Rückelektrodenschicht nicht unmittelbar an der Substratschicht an.

In einer weiteren Ausgestaltung ist vorgesehen, dass die Kontaktschicht enthält oder im Wesentlichen gebildet ist aus Mo, W, Ta, Nb, Zr und/oder Co, insbesondere Mo und/oder W, und/oder mindestens ein Metallchalkogenid enthält oder hieraus im Wesentlichen gebildet ist und/oder mindestens eine erste Lage, benachbart zur Barriereschicht, enthaltend oder im Wesentlichen aus Mo, W, Ta, Nb, Zr und/oder Co, insbesondere Mo und/oder W, und mindestens eine zweite Lage, nicht benachbart zur Barriereschicht, enthaltend oder im Wesentlichen aus mindestens einem Metallchalkogenid, umfasst. Die Kontaktschicht grenzt vorzugsweise auf der dem Substrat zugewandten Seite unmittelbar an die Barriereschicht und/oder an der der Frontelektrode zugewandten Seite unmittelbar an die Halbleiterabsorberschicht an. Geeigneter Weise enthält die Kontaktschicht mindestens ein Metallchalkogenid.

Hierbei wird das Metall des Metallchalkogenids der Kontaktschicht bzw. der zweiten Lage der Kontaktschicht vorzugsweise ausgewählt aus Molybdän, Wolfram, Tantal, Zirkonium, Cobalt und/oder Niob und das Chalkogen des Metallchalkogenids vorzugsweise ausgewählt aus Selen und/oder Schwefel, wobei das Metallchalkogenid insbesondere MSe₂, MS₂ und/oder M(Se₁₋ₓ,Sₓ)₂ darstellt mit M = Mo, W, Ta, Zr, Co oder Nb, wobei x beliebige Werte von 0 bis 1 annimmt, z.B. MoSe₂, WSe₂, TaSe₂, NbSe₂, Mo(Se₁₋ₓ,Sₓ)₂, W(Se₁₋ₓ,Sₓ)₂, Ta(Se₁₋ₓ,Sₓ)₂ und/oder Nb(Se₁₋ₓ,Sₓ)₂.

Solche Ausführungsformen haben sich auch als zweckmäßig erwiesen, bei denen das Metall der ersten Lage und das Metall der zweiten Lage der Kontaktschicht übereinstimmen und/oder dass das Metall der ersten Lage und/oder das Metall der zweiten Lage der Kontaktschicht mit dem Metall der Rückelektrodenschicht übereinstimmen und/oder dass das Metall der Kontaktschicht mit dem Metall der Rückelektrodenschicht übereinstimmen.

Ferner weist die Kontaktschicht üblicherweise eine durchschnittliche Dicke von mindestens 5 nm und vorzugsweise nicht mehr als 150 nm, besonders bevorzugt von nicht mehr als 50 nm, auf.

Erfindungsgemäße Dünnschichtsolarmodule mit nochmals gesteigertem Wirkungsgrad erhält man häufig auch dadurch, dass die Halbleiterabsorberschicht mindestens einen Dotierstoff, insbesondere mindestens ein Element ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod, , oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweist.

Der Dotierstoff, insbesondere Natriumionen, liegt dabei in der Kontaktschicht und/oder der Halbleiterabsorberschicht vorteilhafter Weise in einer Dosis im Bereich von 10¹³ bis 10¹⁷ Atomen/cm² insbesondere im Bereich von 10¹⁴ bis 10¹⁶ Atomen/cm², vor.

Die erste Pufferschicht kann sowohl trocken- wie auch nass-chemisch abgeschieden werden. Dabei kann die erste Pufferschicht enthalten oder im Wesentlichen gebildet sein aus CdS oder einer CdS-freien Schicht, insbesondere enthaltend oder im Wesentlichen aus Zn(S,OH) oder In₂S₃. Die zweite Pufferschicht enthält vorzugsweise oder ist im Wesentlichen gebildet aus intrinsisch leitendem Zinkoxid und/oder hochohmigem Zinkoxid.

Das für die Frontelektrode verwendete Material ist vorzugsweise transparent für elektromagnetische Strahlung, insbesondere für Strahlung mit einer Wellenlänge im Bereich des Absorptionswellenlängenbereichs des Halbleiters. Geeignete Frontelektrodenmaterialien für photovoltaische Dünnschichtsolarzellen sowie deren Applikation sind dem Fachmann bekannt. In einer Ausführungsform enthält die Frontelektrode oder ist im Wesentlichen gebildet aus n-dotiertem Zinkoxid.

Erfindungsgemäße Dünnschichtsolarmodule zeichnen sich in besonders geeigneten Ausgestaltungen auch dadurch aus, dass die durchschnittliche Dicke der

Rückelektrodenschicht im Bereich von 50 nm bis 500 nm, insbesondere im Bereich von 80 nm bis 250 nm, und/oder die der Barriereschicht im Bereich von 10 nm bis 250 nm, insbesondere im Bereich von 20 nm bis 150 nm, und/oder die der Kontaktschicht im Bereich von 2 nm bis 200 nm, insbesondere im Bereich von 5 nm bis 100 nm, und/oder die der Halbleiterabsorberschicht im Bereich von 400 nm bis 2500 nm, insbesondere im Bereich von 500 nm bis 2000 nm und vorzugsweise im Bereich von 800 nm bis 1600 nm, und/oder die der ersten Pufferschicht im Bereich von 5 nm bis 100 nm, insbesondere im Bereich von 10 nm bis 70 nm, und/oder die der zweiten Pufferschicht im Bereich von 10 nm bis 150 nm, insbesondere im Bereich von 20 nm bis 100 nm, liegt. Dabei ist die Gesamtdicke der Mehrschicht-Rückelektrode, d.h. des Systems aus Rückelektrode bzw. Bulk-Rückelektrode, Barriereschicht und Kontaktschicht, vorzugsweise so einzustellen, dass der spezifische Gesamtwiderstand dieser Mehrschicht-Rückelektrode 50 microOhm*cm, bevorzugt 10 microOhm*cm, nicht überschreitet. Unter diesen Vorgaben lassen sich Ohm'sche Verluste in einem serienverschalteten Modul nochmals besonders effizient reduzieren.

Hohe Wirkungsgrade stellen sich mit erfindungsgemäßen Dünnschichtsolarmodulen auch mit solchen Ausführungsformen ein, bei denen die Rückelektrodenschicht Molybdän und/oder Wolfram, insbesondere Molybdän, enthält oder im Wesentlichen aus Molybdän und/oder Wolfram, insbesondere Molybdän, gebildet ist, die leitfähige Barriereschicht TiN enthält oder im Wesentlichen aus TiN gebildet ist, und die Kontaktschicht MoSe₂ enthält oder im Wesentlichen aus MoSe₂ gebildet ist.

Die ersten, zweiten, dritten und/oder vierten Strukturierungstrenngräben weisen in zweckmäßigen Ausgestaltungen erfindungsgemäßer Dünnschichtsolarmodule mindestens abschnittsweise, insbesondere vollständig, eine durchschnittliche Breite von nicht mehr als 50 µm, insbesondere von nicht mehr als 30 µm und vorzugsweise von nicht mehr als 15 µm, auf.

Dabei kann bei erfindungsgemäßen Dünnschichtsolarmodulen auch vorgesehen sein, dass, insbesondere benachbarte, erste und zweite und/oder, insbesondere benachbarte, erste und dritte und/oder, insbesondere benachbarte, zweite und dritte Strukturierungsgräben, oder, insbesondere benachbarte, erste, zweite und dritte Strukturierungsgräben oder, insbesondere benachbarte, erste und vierte Strukturierungstrenngräben mindestens abschnittsweise im Wesentlichen parallel verlaufen.

Des Weiteren hat es sich in Ausgestaltungen der Erfindung als vorteilhaft erwiesen, dass benachbarte erste Strukturierungstrenngräben und/oder benachbarte zweite Strukturierungstrenngräben und/oder benachbarte dritte Strukturierungstrenngräben und/oder benachbarte vierte Strukturierungstrenngräben mindestens abschnittsweise einen durchschnittlichen Abstand im Bereich von 3 mm bis 10 mm, insbesondere von 4 mm bis 8 mm, aufweisen.

Dabei kann auch vorgesehen sein, dass benachbarte erste und zweite Strukturierungstrenngräben und/oder benachbarte zweite und dritte Strukturierungstrenngräben und/oder benachbarte erste und vierte Strukturierungstrenngräben mindestens abschnittsweise, insbesondere vollständig, einen durchschnittlichen Abstand im Bereich von 5 µm bis 100 µm, insbesondere im Bereich von 10 µm bis 50 µm, aufweisen.

Bedingt durch die sehr schmal ausgestaltbaren Strukturierungstrenngräben und/oder bedingt durch die geringen Abstände zwischen benachbarten Strukturierungstrenngräben gelingt es, die effektive Fläche einer Solarzelle, d.h. diejenige Fläche, die für die Umwandlung von Sonnenenergie zur Verfügung steht, zu optimieren bzw. möglichst groß zu gestalten.

Bei erfindungsgemäßen Dünnschichtsolarmodulen sind die ersten Strukturierungstrenngräben regelmäßig über das Niveau der Halbleiterabsorberschicht, insbesondere über das Niveau der Pufferschicht, hinaus mit dem Isolatormaterial befüllt. Hierbei liegt der Brückenwiderstand über den mit Isolator befüllten ersten Strukturierungstrenngraben vorzugsweise oberhalb von 50 kOhm, insbesondere oberhalb von 100 kOhm.

Bei erfindungsgemäßen Dünnschichtsolarmodulen liegen regelmäßig mindestens zwei, insbesondere eine Vielzahl an, monolithisch integriert serienverschalteten Solarzellen.

Die der Erfindung zugrunde liegende Aufgabe wird des Weiteren gelöst durch ein Verfahren zur Herstellung einer ersten Ausgestaltung des erfindungsgemäßen Dünnschichtsolarmoduls, umfassend:
a) Zurverfügungstellung einer, insbesondere flächigen, Substratschicht,
b) Aufbringen mindestens einer Rückelektrodenschicht, insbesondere auf der Substratschicht,
c) Aufbringen mindestens einer leitfähigen Barriereschicht, insbesondere auf der Substratschicht oder auf der Rückelektrodenschicht oder auf der Substratschicht und auf der Rückelektrodenschicht, insbesondere auf der Rückelektrodenschicht, welche unmittelbar auf der Substratschicht angebracht worden ist,
d) Aufbringen mindestens einer, insbesondere Ohm'schen, Kontaktschicht, insbesondere auf der Barriereschicht,
e) Aufbringen mindestens einer, insbesondere Kesterit- oder Chalkopyrit-, Halbleiterabsorberschicht, insbesondere auf der Kontaktschicht,
f) gegebenenfalls Aufbringen mindestens einer ersten Pufferschicht, insbesondere auf der Halbleiterabsorberschicht,
g) gegebenenfalls Aufbringen mindestens einer zweiten Pufferschicht, insbesondere auf der ersten Pufferschicht oder der Halbleiterabsorberschicht,
h) Aufbringen mindestens einer Frontelektrodenschicht, insbesondere auf der Halbleiterabsorberschicht oder der ersten oder zweiten Pufferschicht,
i) mindestens einen ersten Strukturierungsschritt, umfassend Entfernen der auf die Substratschicht aufgebrachten Schichten entlang voneinander beabstandeter Linien mittels Laserbehandlung (erste Laserbehandlung) unter Ausbildung erster Strukturierungstrenngräben, welche benachbarte Solarzellen trennen,
j) mindestens einen zweiten Strukturierungsschritt, umfassend
   j1) Entfernen derjenigen Schichten, die sich von der Kontaktschicht oder von der Rückelektrodenschicht oder von der Barriereschicht, insbesondere von der Barriereschicht, bis einschließlich zu der Frontelektrodenschicht erstrecken, entlang voneinander beabstandeter Linien unter Ausbildung zweiter Strukturierungstrenngräben, welche zu ersten Strukturierungstrenngräben benachbart sind oder an diese angrenzen und insbesondere mindestens abschnittsweise im Wesentlichen parallel zu diesen verlaufen, oder
   j2) chemische Phasenumwandlung und/oder thermischer Zersetzung derjenigen Schichten, die sich von der Kontaktschicht oder von der Rückelektrodenschicht oder von der Barriereschicht, insbesondere von der Barriereschicht, bis einschließlich zu der Frontelektrodenschicht erstrecken, entlang voneinander beabstandeter Linien unter Ausbildung erster linienförmiger leitfähiger Bereiche, welche zu ersten Strukturierungstrenngräben benachbart sind oder an diese angrenzen und insbesondere mindestens abschnittsweise im Wesentlichen parallel zu diesen verlaufen,
k) mindestens einen dritten Strukturierungsschritt, umfassend Entfernen der Schichten, die sich von der Kontaktschicht oder von der Rückelektrodenschicht oder von der Barriereschicht, insbesondere von der Barriereschicht, bis einschließlich zu der Frontelektrodenschicht erstrecken, entlang voneinander beabstandeter Linien unter Ausbildung dritter Strukturierungstrenngräben, welche zu zweiten Strukturierungstrenngräben benachbart sind oder an diese angrenzen und insbesondere abschnittsweise im Wesentlichen parallel zu diesen verlaufen,
l) Füllen der ersten Strukturierungstrenngräben mit mindestens einem Isolatormaterial,
m) Füllen der zweiten Strukturierungstrenngräben mit mindestens einem leitfähigen Material,
n) Ausbilden mindestens einer leitfähigen Brücke mit einem leitfähigen Material von den mit leitfähigem Material befüllten zweiten Strukturierungstrenngräben oder den ersten linienförmigen leitfähigen Bereichen über benachbarte erste, mit dem Isolatormaterial befüllte Strukturierungstrenngräben zu der Frontelektrodenschicht der hierzu benachbarten Solarzelle, so dass benachbarte Solarzellen elektrisch serienverschaltet werden.

Die der Erfindung zugrunde liegende Aufgabe wird außerdem gelöst durch ein Verfahren zur Herstellung einer zweiten Ausgestaltung eines erfindungsgemäßen Dünnschichtsolarmoduls, umfassend:
a) Zurverfügungstellung einer, insbesondere flächigen, Substratschicht,
b) Aufbringen mindestens einer Rückelektrodenschicht, insbesondere auf der Substratschicht,
c) Aufbringen mindestens einer leitfähigen Barriereschicht, insbesondere auf der Substratschicht oder auf der Rückelektrodenschicht oder auf der Substratschicht und auf der Rückelektrodenschicht, insbesondere auf der Rückelektrodenschicht, welche unmittelbar auf der Substratschicht aufgebracht worden ist,
d) Aufbringen mindestens einer, insbesondere Ohm'schen, Kontaktschicht, insbesondere auf der Barriereschicht,
e) Aufbringen mindestens einer, insbesondere Kesterit- oder Chalkopyrit-, Halbleiterabsorberschicht, insbesondere auf der Kontaktschicht,
f) gegebenenfalls Aufbringen mindestens einer ersten Pufferschicht, insbesondere auf der Halbleiterschicht,
g) gegebenenfalls Aufbringen mindestens einer zweiten Pufferschicht, insbesondere auf der ersten Pufferschicht oder auf der Halbleiterabsorberschicht,
h) Aufbringen mindestens einer Frontelektrodenschicht, insbesondere auf der Halbleiterabsorberschicht oder auf der ersten oder zweiten Pufferschicht,
i) mindestens einen ersten Strukturierungsschritt, umfassend Entfernen der auf die Substratschicht aufgebrachten Schichten entlang voneinander beabstandeter Linien mittels Laserbehandlung (erste Laserbehandlung) unter Ausbildung erster Strukturierungstrenngräben, welche benachbarte Solarzellen trennen,
o) mindestens einen vierten Strukturierungsschritt, umfassend Entfernen derjenigen Schichten, die sich von der Kontaktschicht oder von der Rückelektrodenschicht oder von der Barriereschicht, insbesondere von derBarriereschicht, bis einschließlich zu der Frontelektrodenschicht erstrecken, entlang voneinander beabstandeter Linien unter Ausbildung vierter Strukturierungstrenngräben, welche zu ersten Strukturierungstrenngräben benachbart sind oder an diese angrenzen und insbesondere mindestens abschnittsweise im Wesentlichen parallel zu diesen verlaufen,
p) Füllen der ersten Strukturierungstrenngräben mit mindestens einem Isolatormaterial,
q) Füllen eines ersten Volumenbereichs der vierten Strukturierungstrenngräben, der sich von der Barriereschicht bis zur Frontelektrodenschicht entlang der zum ersten Strukturierungstrenngraben benachbarten Trenngrabenwand erstreckt mit mindestens einem leitfähigen Material, unter Nichtbefüllung/Freilassung eines hierzu benachbarten zweiten Volumenbereich, der sich von der Barriereschicht bis zur Frontelektrodenschicht entlang derjenigen Trenngrabenwand erstreckt, die nicht zum ersten Strukturierungstrenngraben benachbart ist,
r) Ausbilden mindestens einer leitfähigen Brücke mit einem leitfähigen Material von den mit leitfähigem Material befüllten ersten Volumenbereichen der vierten Strukturierungstrenngräben über benachbarte erste, mit dem Isolatormaterial befüllte Strukturierungstrenngräben zu der Frontelektrodenschicht der hierzu benachbarten Solarzelle, so dass benachbarte Solarzellen elektrisch serienverschaltet werden.

Das Füllen der zweiten Strukturierungstrenngräben mit mindestens einem leitfähigen Material und das Ausbilden mindestens einer leitfähigen Brücke mit einem leitfähigen Material von den mit leitfähigem Material befüllten zweiten Strukturierungstrenngräben über benachbarte erste, mit dem Isolatormaterial befüllte Strukturierungstrenngräben zu der Frontelektrodenschicht der hierzu benachbarten Solarzelle, so dass benachbarte Solarzellen serienverschaltet werden, kann bei der Herstellung der ersten Ausgestaltung des erfindungsgemäßen Dünnschichtsolarmoduls auch in einem Verfahrensschritt bzw. einem Arbeitsgang vorgenommen werden, d.h. die Schritte m) und n) können auch zu einem Schritt s) zusammengefasst werden.

Des Weiteren ist es bei der Herstellung der ersten Ausgestaltung des erfindungsgemäßen Dünnschichtsolarmoduls möglich, dass die Reihenfolge der Schritte i), j1), k), l) und m) beliebig ist, solange I), unmittelbar oder mittelbar, nach i) kommt und m), unmittelbar oder mittelbar, nach j1) kommt oder dass die Reihenfolge der Schritte i), j2), k) und l) beliebig ist, solange I), unmittelbar oder mittelbar, nach i) kommt. Bevorzugt ist die Abfolge i), j1), l), k), m) und n) oder i), j1), l), k) und s) bzw. i), j2), l), k) und n).

Die chemische Phasenumwandlung in Schritt j2) erfolgt vorzugsweise durch thermische Zersetzung derjenigen Schichten, die sich von der Barriereschicht bis einschließlich zu der Frontelektrodenschicht erstrecken, insbesondere mittels Laserbehandlung. Hierdurch wird entlang von mit z.B. Laserlicht behandelten Linien die Leitfähigkeit der genannten Schichten gegenüber den benachbarten unbehandelten Schichten deutlich erhöht. Dieses erlaubt, diese linienhaft behandelten Schichten, ähnlich wie mit leitfähigem Material befüllte zweite Strukturierungstrenngräben, zur Kontaktierung in der elektrischen Serienverschaltung benachbarter Solarzellen zu benutzen. Dem Fachmann sind für die Phasenumwandlung geeignete Laserlichtwellenlängen und -pulsdauern bekannt. Geeignete Pulsdauern liegen z.B. oberhalb 1 nano-Sekunde.

Das Füllen der ersten Volumenbereiche der zweiten Strukturierungstrenngräben mit mindestens einem leitfähigen Material und das Ausbilden mindestens einer leitfähigen Brücke mit einem leitfähigen Material von den mit leitfähigem Material befüllten ersten Volumenbereich der zweiten Strukturierungstrenngräben über benachbarte erste, mit dem Isolatormaterial befüllte Strukturierungstrenngräben zu der Frontelektrodenschicht der hierzu benachbarten Solarzelle, so dass benachbarte Solarzellen serienverschaltet werden, kann bei der Herstellung der zweiten Ausgestaltung des erfindungsgemäßen Dünnschichtsolarmoduls auch in einem Verfahrensschritt bzw. einem Arbeitsgang vorgenommen werden, d.h. die Schritte q) und r) können auch zu einem Schritt t) zusammengefasst werden.

Des Weiteren ist es bei der Herstellung der zweiten Ausgestaltung des erfindungsgemäßen Dünnschichtsolarmoduls möglich, dass die Reihenfolge der Schritte i), o), p) und q) beliebig ist, solange p), unmittelbar oder mittelbar, nach i) kommt und q), unmittelbar oder mittelbar, nach o) kommt, Bevorzugt ist die Abfolge i), o), p), q) und r) oder i), o), p) und t).

Die Verfahrensschritte i) und j1), i) und j2), i) und k), j1) und k), j2) und k), i), j1) und k) und/oder i), j2) und k) können in einer Weiterentwicklung auch gleichzeitig vorgenommen werden. Ferner können die Schritte i) und o) auch gleichzeitig vorgenommen werden.

In einer besonders geeigneten Ausführungsform ist das Substrat zumindest bereichsweise für elektromagnetische Strahlung der ersten Laserbehandlung durchlässig. Zweckmäßiger Weise kann diese Laserbehandlung des ersten Strukturierungsschritts, insbesondere durch Laserablation, von der der beschichteten Seite des Substrats abgewandten Seite erfolgen.

In einer weiteren Ausführungsform der erfindungsgemäßen Verfahren ist vorgesehen, dass in dem zweiten und/oder dritten und/oder vierten, insbesondere dem zweiten, Strukturierungsschritt die zweiten, dritten bzw. vierten Strukturierungstrenngräben mittels Laserbehandlung (zweite, dritte bzw. vierte Laserbehandlung) erzeugt werden und/oder dass in dem zweiten und/oder dritten und/oder vierten, insbesondere dem dritten und/oder vierten, Strukturierungsschritt die zweiten, dritten bzw. vierten Strukturierungstrenngräben mechanisch, insbesondere mittels Nadelritzens, erzeugt werden.

Gemäß einer besonders zweckmäßigen Ausführungsform der erfindungsgemäßen Verfahren ist vorgesehen, dass die ersten, zweiten, dritten und/oder vierten Strukturierungstrenngräben und/oder die ersten linienförmigen leitfähigen Bereiche mindestens abschnittsweise, insbesondere vollständig, mit einer durchschnittlichen Breite von nicht mehr als 50 µm, insbesondere von nicht mehr als 30 µm und vorzugsweise von nicht mehr als 15 µm, erzeugt werden.

Eine Weiterentwicklung der erfindungsgemäßen Verfahren sieht auch vor, dass, insbesondere benachbarte, erste und zweite und/oder, insbesondere benachbarte, erste und dritte und/oder, insbesondere benachbarte, zweite und dritte Strukturierungsgräben, oder, insbesondere benachbarte, erste, zweite und dritte Strukturierungsgräben oder, insbesondere benachbarte, erste und vierte Strukturierungstrenngräben oder, insbesondere benachbarte, erste Strukturierungstrenngräben und erste linienförmige leitfähige Bereiche mindestens abschnittsweise im Wesentlichen parallel geführt werden.

Ferner hat sich eine solche Verfahrensführung als vorteilhaft erwiesen, bei der benachbarte erste Strukturierungstrenngräben und/oder benachbarte zweite Strukturierungstrenngräben und/oder benachbarte dritte Strukturierungstrenngräben und/oder benachbarte vierte Strukturierungstrenngräben und/oder benachbarte erste linienförmige leitfähige Bereiche mindestens abschnittsweise in einem durchschnittlichen Abstand von im Bereich von 3 mm bis 10 mm, insbesondere von 4 mm bis 8 mm, erzeugt werden.

Mit den erfindungsgemäßen Verfahren ist es in einer weiteren Ausführungsform ferner möglich, dass benachbarte erste und zweite Strukturierungstrenngräben und/oder benachbarte zweite und dritte Strukturierungstrenngräben und/oder benachbarte erste und vierte Strukturierungstrenngräben und/oder benachbarte erste Strukturierungstrenngräben und erste linienförmige leitfähige Bereiche mindestens abschnittsweise, insbesondere vollständig, in einem durchschnittlichen Abstand im Bereich von 5 µm bis 100 µm, insbesondere im Bereich von 10 µm bis 50 µm, erzeugt werden.

Hierbei ist eine solche Ausführungsform besonders geeignet, bei der benachbarte erste, zweite und dritte oder benachbarte erste und vierte Strukturierungstrenngräben oder benachbarte erste Strukturierungstrenngräben und erste linienförmige leitfähige Bereiche einen geringeren durchschnittlichen Abstand zueinander aufweisen als nicht benachbarte erste, zweite und dritte bzw. nicht benachbarte erste und vierte Strukturierungstrenngräben oder nicht benachbarte erste Strukturierungstrenngräben und erste linienförmige leitfähige Bereiche.

Regelmäßig werden bei der ersten Ausgestaltung des erfindungsgemäßen Verfahrens dritte Strukturierungstrenngräben, insbesondere sämtliche dritten Strukturierungstrenngräben, durch den jeweils benachbarten zweiten Strukturierungstrenngraben oder den ersten linienförmigen leitfähigen Bereich von dem jeweils benachbarten ersten Strukturierungstrenngraben separiert sind.

Bei der Herstellung der Strukturierungstrenngräben erfolgen die erste Laserbehandlung, die zweite Laserbehandlung und/oder die dritte Laserbehandlung vorzugsweise mit Laserlichtpulsen mit einer Pulsdauer im Bereich von 1 pico-Sekunde bis 1 nano-Sekunde. Im Verfahren für die erste und die zweite Laserbehandlung können zum Beispiel Laserlichtpulse mit einer Pulsdauer kleiner 10 pico-Sekunden zum Einsatz kommen. Der Linienvorschub kann z.B. Geschwindigkeiten von einigen m/sec betragen und ist massenproduktionstauglich.

Der erste, zweite und dritte Strukturierungsschritt der ersten Ausgestaltung des erfindungsgemäßen Verfahrens oder der erste und vierte Strukturierungsschritt der zweiten Ausgestaltung des erfindungsgemäßen Verfahrens führen regelmäßig oder tragen regelmäßig zu einer monolithisch integrierten Serienverschaltung der Solarzellen bei. Diese Strukturierungsschritte sind vorzugsweise als linienhafte Prozessierschritte ausgestaltet.

Als besonders zweckmäßig haben sich auch solche Verfahrensführungen erwiesen, bei denen die, insbesondere mindestens einen Dotierstoff enthaltende, Kontaktschicht enthält oder im Wesentlichen gebildet ist aus Molybdän, Tantal, Zirkonium, Cobalt, Niob und/oder Wolfram (erste Metalllage) und/oder mindestens einem Metallchalkogenid ausgewählt aus Metallselenid, Metallsulfid und/oder Metallsulfoselenid mit Metall = Mo, W, Ta, Zr, Co oder Niob, insbesondere ausgewählt aus der Gruppe bestehend aus MoSe₂, WSe₂, MoS₂, WS₂, Mo(Se₁₋ₓ,Sₓ)₂ und/oder W(Se₁₋ₓ,Sₓ)₂, wobei x beliebige Werte von 0 bis 1 annimmt.

Die erfindungsgemäßen Verfahren sehen vorzugsweise vor, dass die Halbleiterabsorberschicht eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,Sₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellt oder umfasst, wobei x Werte von 0 bis 1 annimmt.

Als besonders vorteilhaft hat sich außerdem eine solche Vorgehensweise erwiesen, bei der durch das Aufbringen der Kesterit- oder Chalkopyrit-Halbleiterabsorberschicht auf der Kontaktschicht in der Kontaktschicht vorliegende Metalle oder diese Kontaktschicht bildende Metalle vollständig oder partiell zu Metallseleniden, Metallsulfiden und/oder Metallsulfoseleniden umgewandelt werden.

Das erfindungsgemäße Verfahren kann dabei z.B. derart vorgenommen werden, dass die Kontaktschicht eine Schichtenabfolge umfasst aus mindestens einer Metallschicht und mindestens einer Metallchalkogenidschicht, wobei die Metallschicht an der Rückelektrodenschicht oder an der leitfähigen Barrierenschicht anliegt bzw. angrenzt und wobei die Metallchalkogenidschicht an der Halbleiterabsorberschicht anliegt bzw. angrenzt. Von Vorteil sind auch solche Vorgehensweisen, bei denen das Metall der Metallschicht und das Metall der Metallchalkogenidschicht übereinstimmen, insbesondere Molybdän und/oder Wolfram darstellen.

Auch kann das erfindungsgemäße Verfahren beispielsweise derart ausgestaltet werden, dass auf die Barriereschicht mindestens eine erste Metalllage aus z.B. Molybdän, Tantal, Zirkonium, Cobalt, Wolfram und/oder Niob aufgebracht wird und dass diese erste Metalllage bei der Herstellung der Halbleiterabsorberschicht, insbesondere der Kesterit- oder Chalkopyrit-Halbleiterabsorberschicht, in Selen- und/oder Schwefel-haltiger Atmosphäre unter Ausbildung der Kontaktschicht teilweise zu einer Metallchalkogenidschicht umgesetzt wird. Eine weitere Ausgestaltung des erfindungsgemäßen Verfahrens sieht ferner vor, dass auf die Barriereschicht mindestens eine erste Metalllage aus Molybdän, Tantal, Wolfram, Cobalt, Zirkonium und/oder Niob aufgebracht wird und dass diese erste Metalllage bei der Herstellung der Halbleiterabsorberschicht, insbesondere der Kesterit- oder Chalkopyrit-Halbleiterabsorberschicht, in Selen- und/oder Schwefel-haltiger Atmosphäre unter Ausbildung der Kontaktschicht vollständig zu einer Metallchalkogenidschicht umgesetzt wird.

Bei den erfindungsgemäßen Verfahren umfasst der Schritt des Aufbringens der Halbleiterabsorberschicht, insbesondere der Kesterit- oder Chalkopyrit-Halbleiterabsorberschicht, in einer zweckmäßigen Ausführungsform demgemäß die Abscheidung von, insbesondere sämtlichen, metallischen Komponenten der Halbleiterabsorberschicht, insbesondere von Kupfer, Indium und gegebenenfalls Gallium für die Chalkopyrit-Halbleiterabsorberschicht und Kupfer, Zink und Zinn für die Kesterit-Halbleiterabsorberschicht, auf der Kontaktschicht unter Ausbildung einer zweiten Metalllage und das Behandeln dieser zweiten Metalllage mit Selen und/oder einer Selenverbindung sowie gegebenenfalls mit Schwefel und/oder einer Schwefelverbindung, vorzugsweise bei Temperaturen oberhalb von 300°C, insbesondere oberhalb von 350°C.

Bei der Herstellung der Halbleiterabsorberschicht liegen die Umsetzungstemperaturen häufig auch im Bereich von 500°C bis 600°C. Bei derartigen Temperaturen migrieren, insbesondere diffundieren, Dotierstoffe, wie insbesondere Natriumionen bzw. Natriumverbindungen, aus der dotierten Kontaktschicht in die Halbleiterabsorberschicht. Bedingt durch die Barriereschicht findet eine Migration bzw. Diffusion in die Rückelektrodenschicht nicht statt. Aufgrund der genannten relativ hohen Temperaturen bei der Prozessierung des Halbleiters ist es vorteilhaft, dass die ausgewählten Schichten der Mehrschichtrückelektrode, insbesondere die Rückelektrode und/oder die leitfähige Barrierenschicht so zusammengesetzt sind, dass deren linearer thermischer Ausdehnungskoeffizient an den des Halbleiterabsorbers und/oder des Substrates angepasst sind. Daher sollten insbesondere die Rückelektrode und/oder die Barriereschicht der erfindungsgemäßen Dünnschichtsolarmodule vorzugsweise so zusammengesetzt sein, dass ein linearer thermischer Ausdehnungskoeffizient von 14*10^{-6 -}K, bevorzuget von 9*10⁻⁶⁻K nicht überschritten wird.

Bei den erfindungsgemäßen Verfahren kann ferner vorgesehen sein, dass die Rückelektrodenschicht, die leitfähige Barriereschicht, die erste Metalllage, insbesondere enthaltend Mo, die Kontaktschicht, die zweite Metalllage, insbesondere enthaltend Cu, In und Ga, die erste Pufferschicht, die zweite Pufferschicht und/oder die Frontelektrodenschicht erhalten werden mittels physikalischer Gasphasenabscheidung, insbesondere umfassend Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mittels chemischer Gasphasenabscheidung, insbesondere umfassend Chemical Vapour Deposition (CVD), Niedrigdruck- (low pressure) CVD und/oder Atmosphären- (atmospheric pressure) CVD.

Hierbei ist von besonderem Vorteil, dass das Aufbringen der Rückelektrodenschicht, der leitfähigen Barriereschicht, der ersten Metalllage oder der Kontaktschicht und der zweiten Metalllage in einer einzigen Vakuum-Beschichtungsanlage, vorzugsweise im Durchlauf-Sputterverfahren, erfolgen können.

Außerdem ist bei den erfindungsgemäßen Verfahren von Vorteil, dass der erste und der zweite Strukturierungsschritt und der Schritt des Verfüllens des ersten Strukturierungsgrabens mit dem Isolatormaterial in einer einzigen Anlage erfolgen können. Die Strukturierungsschritte des erfindungsgemäßen Verfahrens sowie die Befüllschritte können, soweit sie nicht sachlogisch nacheinander erfolgen müssen, in Teilen oder auch vollständig gleichzeitig erfolgen bzw. vorgenommen werden. Beispielsweise kann hierfür auf Mehrschicht-Kopf-Anordnungen für Laser- und Ink-Jet- oder Aerosol-Jet-Vorrichtungen zurückgegriffen werden, mit denen parallel mehrere Gräben prozessiert und aufgefüllt werden können.

Es kann erfindungsgemäß bevorzugt sein, dass zum Aufbringen von leitfähigen oder weiteren Strukturen mittels erfindungsgemäßer Laser- und Ink-Jet- oder Aerosol-Jet-Vorrichtungen eine Tinte, vorzugsweise eine Hotmelt-Aerosol-Tinte, zerstäubt wird und dadurch ein leitfähiger Kontakt auf das Substrat aufgebracht wird, wobei die Laser- und Ink-Jet- oder Aerosol-Jet- Vorrichtungen mindestens teilweise beheizbar oder beheizt sind, vorzugsweise mit der Maßgabe, dass die eingesetzte Tinte eine Viskosität von η ≤ 1 Pas bei einer Temperatur von mindestens 40°C aufweist. Dies ist beispielhaft in der DE 10 2007 058 972 A1 beschrieben, welche hiermit durch diesen Verweis eingebunden ist.

Auch kann es vorteilhaft sein, wenn eine Tinte für insbesondere die Ink-Jet und/oder die Aerosol-Jet-Vorrichtung(en) Metallpartikel umfasst, insbesondere Metallpartikel ausgewählt aus einer Gruppe bestehend aus Silber, Zinn, Zink, Chrom, Cobalt, Wolfram, Titan und/oder deren Mischungen. Alternativ oder zusätzlich kann die Tinte die Metalloxide, beispielsweise Bleioxid, Bismuthoxid, Titanoxid, Aluminiumoxid, Magnesiumoxid und/oder deren Mischungen, enthalten.

Auch kann es vorteilhaft sein, wenn die Tinte thermoplastische Verbindungen ausgewählt aus der Gruppe bestehend aus C₁₆ bis C₂₀, bevorzugt C₁₄ bis C₁₆ linearen aliphatischen Alkoholen und/oder mehrwertigen Alkohole, wie Hexan-1,6-diol enthält.

Erfindungsgemäß kann auch bevorzugt sein, dass das in der Tinte enthaltene Lösungsmittel ausgewählt ist aus Glykolether, M-Methylpyrolidon, 2-(2-Butoxyethoxy)ethanol und/oder deren Mischungen.

Auch kann bevorzugt sein, dass die Tinte als Additive Diespergiermittel und/oder Entschäumer enthält.

Die Strukturierungsgräben können dabei z.B. über die Länge eines Dünnschichtsolarmoduls in einem durchgehenden Arbeitsgang gefertigt werden. Beispielsweise können auf diese Art Strukturierungsgräben mit einer Länge von 1,6 m und mehr erhalten werden. Eine Begrenzung der Länge der Strukturierungsgräben kann z.B. durch die Länge des Moduls oder Substrats oder durch anlagentechnische Vorgaben gegeben sein, nicht jedoch durch das erfindungsgemäße Verfahren selber.

Das Verfüllen des ersten Strukturierungsgrabens mit dem Isolatormaterial und/oder das Verfüllen des zweiten Strukturierungsgrabens oder des ersten Volumenbereichs des vierten Strukturierungsgrabens mit leitfähigem Material erfolgt in einer bevorzugten Ausführungsform mit dem Ink-Jet- oder mit dem Aerosol-Jet-Verfahren. Mit dem Inkjet-Verfahren lassen sich das Isolatormaterial wie auch das leitfähige Material sehr fein dosieren, wie es z.B. auch aus der Tintenstrahl-Druckerindustrie bekannt ist. Beispielsweise können mittels Ink-Jet-Verfahren und/oder mit dem Aerosol-Jet-Verfahren Tröpfchen mit einem Volumen im Bereich von etwa 10 pico-Litern bis unter einem pico-Liter feindosiert und z.B. mit Präzisions-xyz-Tisch präzise justiert in die Strukturierugstenngräben verfüllt bzw. gespritzt werden. Des Weiteren ermöglichen derartig geringe Tropfenvolumina auch eine nur teilweise Befüllung eines Strukturierungstrenngrabens, z.B. über Tropfengröße, Tropfen-Rate und/oder Vorschub und/oder durch entsprechende laterale Justage. Zum Beispiel kann der zweite Strukturierungsgraben über eine Höhe von etwa 3 Micrometer bei einer Breite von etwa 20 Micrometer verfügen. Bei einem derartigen Aspektverhältnis ist es z.B. ohne weiteres möglich, in einem einzigen Arbeitsgang den ersten Strukturierungstrenngraben vollständig mit Isolatormaterial und den zweiten Strukturierungstrenngraben teilweise, d.h. im ersten Volumenbereich, mit leitfähigem Material zu befüllen und außerdem eine leitfähige Brücke von diesem ausgefüllten ersten Volumenbereich zu der Frontelektrode der benachbarten Solarzelle zu bilden.

Als Verfüllmaterial für das Isolatormaterial kann zum Beispiel eine schnell härtende Isolatortinte oder ein UV-härtender elektrisch isolierender Lack verwendet werden, wie er aus der Halbleitertechnologie bekannt ist. Die UV-Beleuchtung erfolgt vorzugsweise unmittelbar nach dem Verfüllschritt.

Der vorliegenden Erfindung liegt die überraschende Erkenntnis zugrunde, dass sich durch die Abfolge der Strukturierungsprozesse, insbesondere in Kombination mit der einer Mehrschicht-Rückelektrode, enthaltend eine insbesondere bidirektionale Barriereschicht, photovoltaische Dünnschichtsolarmodule mit monolithisch integriert serienverschalteten Solarzellen in der Massenfertigung in hoher Qualität und mit hohen Wirkungsgraden kosteneffizient und reproduzierbar erhalten lassen. Hierbei ist ferner von Vorteil, dass das Zell- und Modul-Formatdesign in weiten Bereichen auch in der Massenfertigung variierbar ist und entsprechende Kundenwünsche in großem Umfang berücksichtigt und umgesetzt werden können. Dieses trifft gleichfalls auf die vom Kunden für ein Dünnschichtsolarmodul gewünschte Leerlaufspannung und den Kurzschlussstrom zu. Dadurch dass die Strukturierung der Solarzellen erst nach der Abscheidung sämtlicher Schichten bis zur Frontelektrodenschicht stattfindet, werden auch keine Angriffspunkte für Beeinträchtigungen während der Herstellung der Halbleiterabsorberschicht geliefert, welche regelmäßig unter aggressiven Bedingungen stattfindet, d.h. bei hohen Temperaturen und in Anwesenheit von z.B. Selenwasserstoff, Schwefelwasserstoff, elementarem Selen- und/oder elementarem Schwefeldampf. Beispielsweise kann eine Unterwanderung von Einzelschichten unter Bildung von Metallchalkogeniden ausgeschlossen werden. Denn bei den aus dem Stand der Technik bekannten Verfahren werden die Strukturiergräben vor dem Halbleiterbildungsprozess hergestellt, weshalb die Strukturiergräben unter Einwirkung der bei der Halbleiterbildung angewendeten hohen Temperaturen und gegebenenfalls auch Alkalidiffusion im Bereich von 350°C bis 600°C stehen und unter Selen- bzw. Schwefeleinwirkung dann häufig korrodieren. Hiermit einhergehend erfolgen eine Schichtunterwanderung und die Bildung von Mikrorissen durch mechanischen Stress, hervorgerufen durch die Volumenexpansion der unter Selen- und/oder Schwefeleinwirkung korrodierten Metalle. Mit dem erfindungsgemäßen Verfahren werden diese Nachteile umgangen. Demzufolge gelangt man zu Dünnschichtsystemen mit verbesserter Haftung und zu einem Schichtaufbau aus Einzelschichten, welche sich durch eine ebenere Oberfläche gegenüber nach Verfahren aus dem Stand der Technik erhaltenen Dünnschichtsolarmodulen auszeichnen. Grenzflächenrauhigkeiten bzw. Schichtdickenfluktuationen werden nicht mehr beobachtet. Ferner liegen während der Bildung der Halbleiterabsorberschicht keine aufgetrennten Rückelektroden mehr vor, so dass eine Oberflächenkorrosion an den Strukturgrabenflanken nicht mehr zu befürchten ist. Das Risiko von Mikrorissen wird hierdurch verringert oder gar unterbunden. Ferner kann die Bildung eines Strukturierungsrandes bei der Laserstrukturierung durch Aufschmelzen des Rückelektrodenmetalls vermieden werden. Ein solcher Schmelzrand ist im Allgemeinen besonders empfänglich für eine Reaktion mit Selen und/oder Schwefel unter den Bildungsbedingungen der Halbleiterabsorberschicht. Eine ausgeprägte Volumenexpansion mit der Folge von Mikrorissen kann häufig nicht verhindert werden. Derartige Probleme treten mit den erfindungsgemäßen Dünnschichtsolarmodulen nicht mehr auf.

Von Vorteil bei den erfindungsgemäßen Dünnschichtsolarmodulen ist auch, dass sich eine möglichst große photovoltaisch aktive Fläche verlässlich pro Solarzelle zur Verfügung stellen lässt, welche für die Energiegewinnung genutzt werden kann. Hierzu tragen die sehr schmal gestaltbaren Strukturierungstrenngräben ebenso bei wie die auf ein Mindestmaß einstellbaren Abstände zwischen benachbarten Strukturierungstrenngräben.

Das erfindungsgemäße Verfahren gestattet es zudem, die sonst häufig auftretende Schädigung der isolierenden Barriereschicht beim Laserprozess zu umgehen. Folglich kann verhindert werden, dass Alkaliionen unkontrolliert aus dem Substratglas in die Halbleiterabsorberschicht gelangen. Durch die Vermeidung der Überdotierung der Halbleiterabsorberschicht und durch das Verfüllen des Strukturiergrabens mit Isolatorfüllmaterial wird der gewünschte hohe Brückenwiderstand zwischen benachbarten Zellen gegenüber dem Stand der Technik deutlich verbessert, so dass ein signifikanter Füllfaktor- bzw. Wirkungsgradgewinn die Folge ist. Des Weiteren wird durch die kontrollierte Dotierung der Halbleiterabsorberschicht sichergestellt, dass durch Alkaliionen induzierte Haftungsprobleme der einzelnen Schichten bei dem nach dem erfindungsgemäßen Verfahren erhaltenen Dünnschichtsolarmodul nicht mehr auftreten. Der Anteil an nicht zu verwendender Ausschussware kann damit drastisch verringert werden.

Mit den erfindungsgemäßen Dünnschichtsolarmodulen lassen sich höhere Füllfaktoren und verbesserte Wirkungsgrade verwirklichen.

Als vorteilhaft hat sich auch erwiesen, dass sich mehrere Verfahrensschritte in einer einzigen Anlage durchführen lassen. Dieses trifft z.B. auf den ersten und zweiten Strukturierungsschritt und das Verfüllen des ersten Strukturierungstrenngrabens mit einem Isolatormaterial zu. Das erfindungsgemäße Verfahren erlaubt demgemäß eine kostengünstigere Prozessierung bei merklicher Leistungsverbesserung. Auch lässt sich die Halbleiterabsorberschicht wesentlich gezielter mit Dotierstoffen versehen.

Weitere Merkmale und Vorteile der Erfindung ergeben sich aus der nachgehenden Beschreibung, in der bevorzugte Ausführungsformen der Erfindung beispielhaft anhand schematischer Zeichnungen erläutert sind. Dabei zeigen:
- Figur 1: eine schematische Querschnittsansicht einer Fertigungsstufe einer ersten Ausführungsform des erfindungsgemäßen Dünnschichtsolarmoduls, erhalten nach einer ersten Ausführungsform des erfindungsgemäßen Verfahrens;
- Figur 2: eine schematische Querschnittsansicht einer nachfolgenden Fertigungsstufe des erfindungsgemäßen Dünnschichtsolarmoduls erhalten nach dem erfindungsgemäßen Verfahren;
- Figur 3: eine schematische Querschnittsansicht einer weiteren Fertigungsstufe des erfindungsgemäßen Dünnschichtsolarmoduls erhalten nach dem erfindungsgemäßen Verfahren;
- Figur 4: eine schematische Querschnittsansicht einer weiteren Fertigungsstufe des erfindungsgemäßen Dünnschichtsolarmoduls erhalten nach dem erfindungsgemäßen Verfahren;
- Figur 5: eine schematische Querschnittsansicht einer weiteren Fertigungsstufe des erfindungsgemäßen Dünnschichtsolarmoduls erhalten nach dem erfindungsgemäßen Verfahren;
- Figur 6: eine schematische Querschnittsansicht einer weiteren Fertigungsstufe des erfindungsgemäßen Dünnschichtsolarmoduls erhalten nach dem erfindungsgemäßen Verfahren;
- Figur 7: eine schematische Querschnittsansicht einer Fertigungsstufe einer alternativen Ausführungsform des erfindungsgemäßen Dünnschichtsolarmoduls, erhalten gemäß einer alternativen Ausführungsform des erfindungsgemäßen Verfahrens;
- Figur 8: eine schematische Querschnittsansicht einer weiteren Fertigungsstufe der alternativen Ausführungsform des erfindungsgemäßen Dünnschichtsolarmoduls, aufbauend auf der Fertigungsstufe gemäß Fig. 7;
- Figur 9: eine schematische Querschnittsansicht einer Fertigungsstufe einer weiteren alternativen Ausführungsform des erfindungsgemäßen Dünnschichtsolarmoduls, erhalten nach einer alternativen Ausführungsform des erfindungsgemäßen Verfahrens; und
- Figur 10: eine schematische Querschnittsansicht einer weiteren Fertigungsstufe der alternativen Ausführungsform des erfindungsgemäßen Dünnschichtsolarmoduls, aufbauend auf der Fertigungsstufe gemäß Fig. 9.

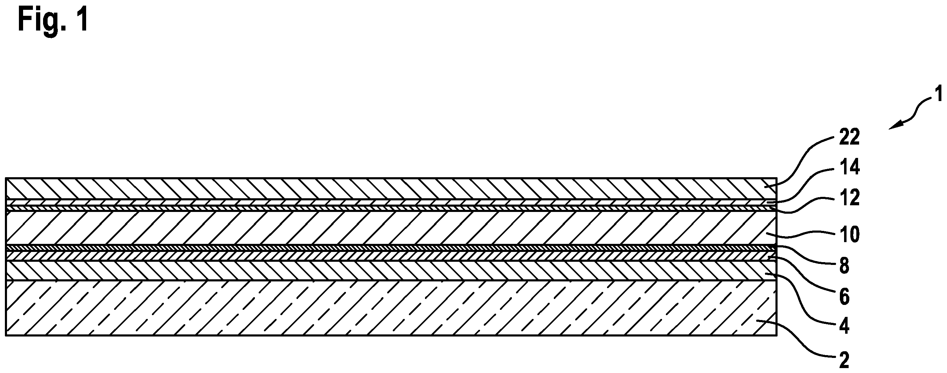

Figur 1 entnimmt man eine schematische Querschnittsansicht einer intermediären Fertigungsstufe la eines erfindungsgemäßen Dünnschichtsolarmoduls 1. Auf dem Glassubstrat 2 liegt mittels Dünnschichtabscheidung eine Bulk-Rückelektrodenschicht 4 z.B. aus Molybdän vor. Hieran angrenzend liegt eine bidirektionale, reflektierende Barriereschicht 6 aus z.B. TiN oder ZrN auf, die ebenfalls mittels Dünnschichtabscheidung erhalten werden kann. Auf der Barriereschicht 6 liegt in der dargestellten Ausführungsform eine Ohm'sche Kontaktschicht 8 aus einem Metallchalkogenid wie Molybdänselenid auf. Diese Kontaktschicht kann auf unterschiedliche Art und Weise, wie vorangehend bereits allgemein erläutert, erhalten werden. In einer Ausgestaltung ist z.B. Molybdänselenid aus einem Molybdänselenidtarget aufgesputtert worden. Alternativ kann zunächst eine Metallschicht aufgetragen werden, welche anschließend vor und/oder während der Bildung der Halbleiterabsorberschicht in das entsprechende Metallchalkogenid umgewandelt wird. Die Kontaktschicht 8 kann dabei in einer bevorzugten Ausführungsform auch mit mindestens einem Dotierstoff versetzt sein, beispielsweise Natriumionen oder einer Natriumverbindung, insbesondere Natriumsulfit oder Natriumsulfid. Die Schicht 10 stellt die Halbleiterabsorberschicht dar und kann z.B. als Chalkopyrit- oder als Kesterit-Halbleiterabsorberschicht vorliegen. Verfahren zur Auftragung dieser Halbleiterabsorberschichten sind dem Fachmann bekannt. Liegt in der Kontaktschicht ein Dotierstoff vor, diffundiert dieser in der Regel unter den Bedingungen der Bildung der Halbleiterabsorberschicht in letztere. Mittels Dünnschichtabscheidung sind dann auf die Halbleiterabsorberschicht 10 zunächst die erste Pufferschicht 12 aus z.B. CdS, Zn(S,OH) oder In₂S₃ und die zweite Pufferschicht 14 aus intrinsischem Zinkoxid appliziert worden sowie anschließend die Frontelektrodenschicht 22 aus n-dotiertem Zinkoxid.

Die in Figur 1 dargestellte Schichtabfolge 2, 4, 6, und 8 eines erfindungsgemäßen Dünnschichtsolarmoduls 1 kann in einer einzigen Anlage in einem im Wesentlichen zusammenhängenden Prozess gefertigt werden. Während der gesamten Prozessspanne kann in einer einzigen Anlage prozessiert werden. Somit werden nicht nur kostenträchtige Verfahrensschritte vermieden, sondern ebenfalls die Gefahr der Kontamination der Produktzwischenstufen, beispielsweise mit Sauerstoff, reduziert.

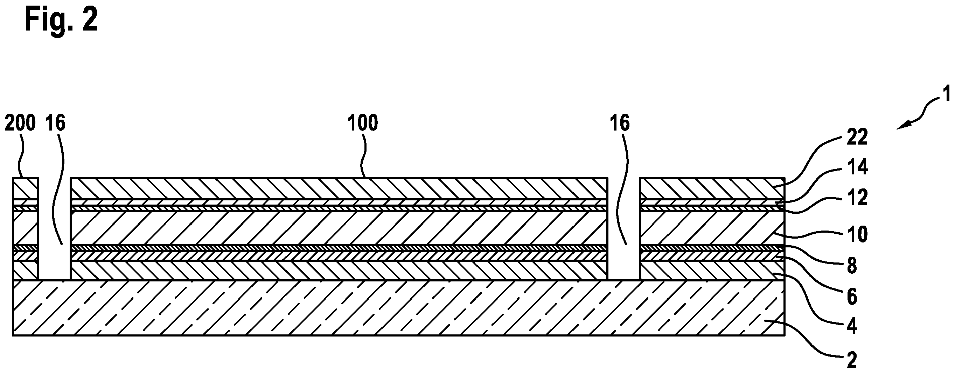

Figur 2 zeigt den an der Fertigungszwischenstufe la vorgenommenen ersten Strukturierungsschritt unter Erhalt der Fertigungsstufe 1b. Mittels Laserbehandlung von der Unterseite (angedeutet durch Pfeilsymbole) des transparenten Substrats 2 sind erste Trenngräben 16 erzeugt worden, welche letztendlich die Breiten der Solarzellen der monolithisch integrierten Serienverschaltung festlegen. Durch den ersten Trenngraben 16 werden beispielsweise die Solarzellen 100 und 200 voneinander getrennt. Auf diese Weise sind z.B. über eine durchschnittliche Trenngrabenbreite von 15 µm entlang von Linien sämtliche oberhalb des Substrats vorliegenden Schichten entfernt worden, einschließlich der Frontelektrodenschicht.

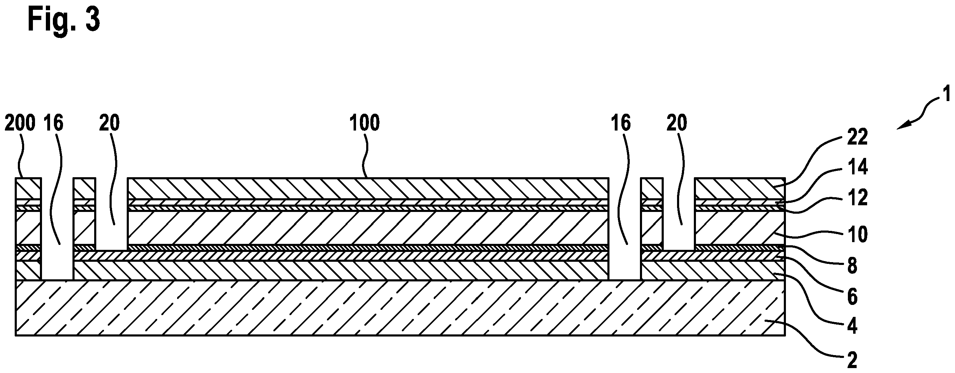

Bei der in Figur 3 wiedergegebenen Fertigungsstufe 1c ist mittels Laserbehandlung ein zweiter Strukturierungsprozess an dem Schichtsystem, diesmal von der Oberseite, unter Ausbildung beabstandeter zweiter Trenngräben 20 vorgenommen worden. Von der Frontelektrodenschicht 22 über die Pufferschichten und die Halbleiterabsorberschicht 10 bis einschließlich der Kontaktschicht 8 sind bis zur Barrierenschicht sämtliche Schichten entfernt worden, vorzugsweise über eine durchschnittliche Breite von 15 µm. Diese zweiten Trenngräben 20 können auch mechanisch, z.B. mittels Nadelritzens erzeugt werden. Sie sind benachbart zu den ersten Trenngräben 16 angebracht und verfügen z.B. über einen durchschnittlichen Abstand kleiner 50 µm, beispielsweise von etwa 30 µm. Erste und zweite Trenngräben 16, 20 liegen hier bevorzugt im Wesentlichen parallel vor.

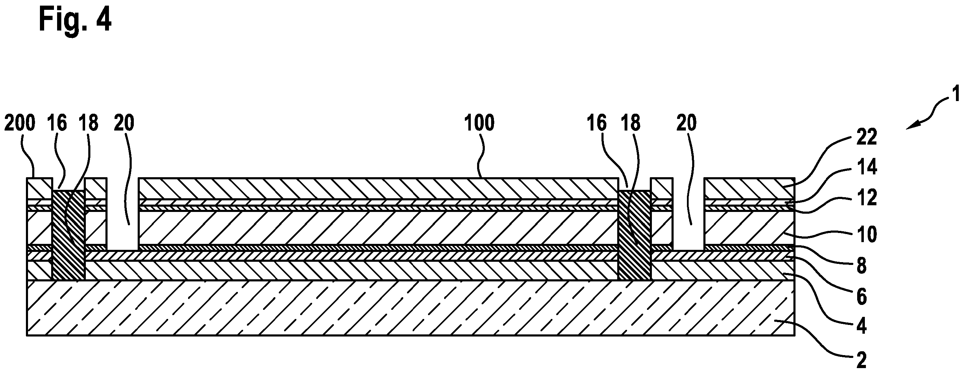

Wie in Fig. 4 gezeigt, können die ersten Trenngräben 16, z.B. mittels Ink-Jet- oder Aerosol-Jet-Verfahren mit einem beispielsweise mit UV-Licht aushärtbaren Isolatormaterial 18 verfüllt werden. Hierbei sollte der erste Trenngraben er vorzugsweise, wie in Fig. gezeigt, bis zur Frontelektrodenschicht 22, d.h. oberhalb der zweiten Pufferschicht 14 mit dem Isolatormaterial 18 verfüllt sein, um spätere Kurzschlüsse im Wandungsbereich der Strukturierflanke auf der Zelle 200 zugewandten Seite zu vermeiden. Man erhält die Fertigungsstufe 1d.

Die Schritte der ersten und zweiten Laserstrukturierung sowie der Verfüllung der ersten Trenngräben mit Isolatormaterial können hierbei bevorzugt in ein und derselben Anlage durchgeführt werden. Hierdurch entfällt eine aufwendige Justage, vielmehr muss diese nur ein einziges Mal erfolgen. Auch können die ersten und zweiten Trenngräben in einem engeren Abstand zueinander angebracht werden, wodurch die photovoltaisch aktive Fläche des Dünnschichtsolarmoduls vergrößert wird.

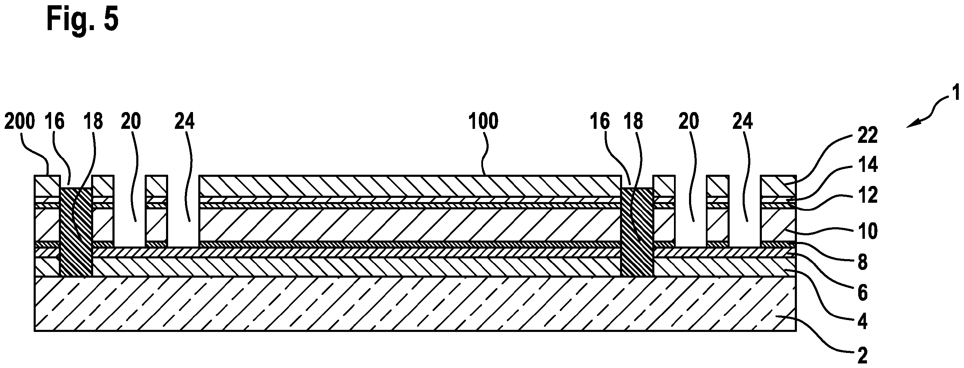

Anschließend wird die Fertigungsstufe 1d zwecks Definition der Isolationsstruktur in der monolithisch integrierten Serienverschaltung dem dritten Strukturierungsschritt unterzogen, bei dem dritte Trenngräben 24 erzeugt werden, die sich wie die zweiten Trenngräben 20 bis zur Barriereschicht 6 erstrecken, Fertigungsstufe le (siehe Figur 5). Sie sind benachbart zu den zweiten Trenngräben 20 angebracht und verfügen z.B. über einen durchschnittlichen Abstand kleiner 50 µm, beispielsweise von etwa 30 µm. Zweite und dritte Trenngräben 20, 24 liegen hier bevorzugt im Wesentlichen parallel vor. Die dritten Trenngräben 24 können mittels Laserbehandlung oder mechanisch, z.B. mittels Nadelritzens, erhalten werden. Die ersten, zweiten und dritten Trenngräben 16, 20 und 24 der Solarzelle 100 bilden zueinander benachbarte Trenngräben im Sinne der vorliegenden Erfindung.

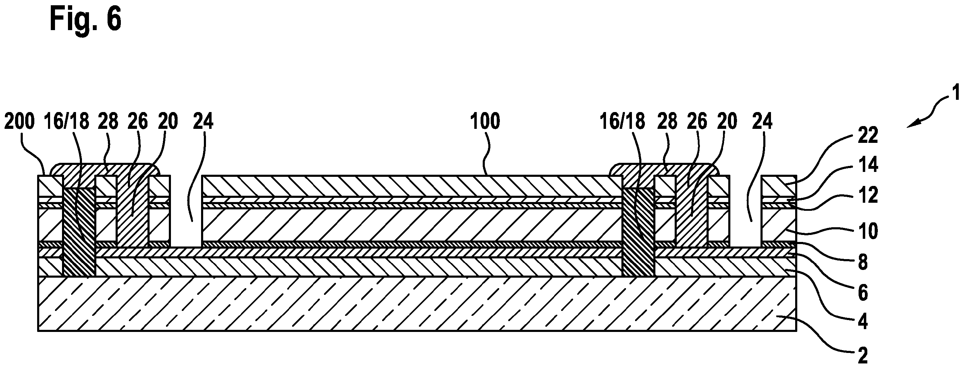

Auf der nächsten, in Fig. 6 wiedergegebenen Verfahrensstufe werden in der dargestellten Ausführungsform die zweiten Trenngräben 20 mit einem hochleitfähigem Material 26 ortsgenau verfüllt und gleichzeitig eine leitfähige Brücke 28 mit diesem leitfähigen Material 26 entlang der Oberfläche der Frontelektrodenschicht 22 über den mit Isolatormaterial 18 verfüllten benachbarten ersten Trenngraben 16 hinweg zu der benachbarten Solarzelle 200, z.B. zu der Frontelektrodenschicht 22 dieser Solarzelle 200 erzeugt. Damit wird ein elektrisch leitender Kontakt zwischen der Rückelektrode 4 der ersten Solarzelle 100 zu der Frontelektrode 22 der benachbarten Solarzelle 200 und mithin eine Serienverschaltung sichergestellt. Der Auftrag des leitfähigen Materials kann z.B. mittels Ink-Jet- oder Aerosoljet-Verfahren erfolgen. Man erhält die Fertigungsstufe 1f.

Bei dem dargestellten Verfahren können die Zielformate der Dünnschichtsolarmodule in einer zweckmäßigen Ausgestaltung mittels Schneidens aus dem Ursprungsformat des Substrats nach der Fertigungsstufe 1f erhalten werden.

Vor oder nach dem Schneiden der Module können weitere gängige Verfahrensstufen angeschlossen werden, beispielsweise der Auftrag einer Laminierfolie und/oder die Anbringung einer Schutzglasschicht. Diese Verfahrensstufen sind dem Fachmann an sich geläufig.

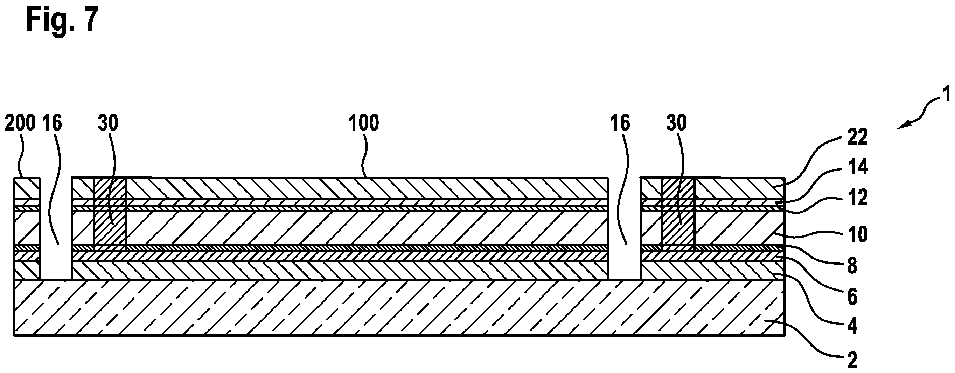

Fig. 7 entnimmt man eine Alternative zu den vorangehend dargestellten Fertigungsstufen 1c und 1f. Anstelle zunächst den zweiten Trenngraben 20 zu erzeugen, um ihn anschließend mit leitfähigem Material zu verfüllen, kann man mittels gezielter Laserbehandlung begrenzt auf z.B. die Breite des zu der vorangehenden ersten Ausführungsform beschriebenen zweiten Trenngrabens einen hochleitfähigen Bereich 30, vorzugsweise parallel zum ersten Trenngraben 16, erzeugen, der einen leitfähigen Pfad von der Rückelektrode 4 zu der Frontelektrode 22 bildet. Durch den räumlich auf den Bereich 30 begrenzten thermischen Eintrag mittels gepulstem Laserlicht wird im vorliegenden Fall eine Phasenumwandlung der Schichten oberhalb der Barriereschicht zu dem hochleitfähigem Pfad herbeigeführt.

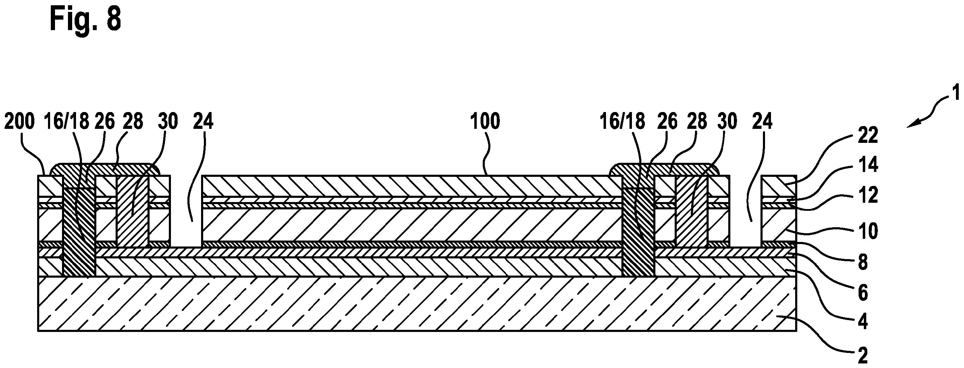

Wie in Fig. 8 zusammengefasst, kann sodann entsprechend den Fertigungsstufen 1d und le zunächst der erste Trenngraben 16 mit Isolatormaterial 18 verfüllt und anschließend der dritte Trenngraben 24 mechanisch oder mittels Laserbehandlung erzeugt werden. Hierauf folgt analog zu der vorangehend beschriebenen Fertigungsstufe 1f die Anbringung einer Brücke 28 aus leitfähigem Material 26 von dem ersten hochleitfähigen Bereich 30 der ersten Solarzelle 100 zu der Frontelektrodenschicht 22 der benachbarten zweiten Solarzelle 200 über den mit Isolatormaterial 18 befüllten ersten Trenngraben 16 hinweg. Auch auf diese Weise gelingt eine Serienverschaltung von jeweils benachbarten Solarzellen des erfindungsgemäßen Dünnschichtsolarmoduls 1.

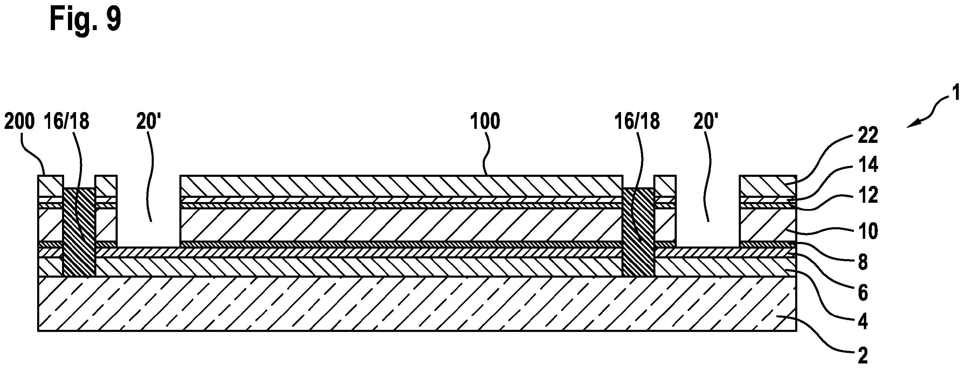

Fig. 9 zeigt eine weitere Alternative auf, um zu den erfindungsgemäßen Dünnschichtsolarmodulen zu gelangen. Zunächst wird ähnlich verfahren wie bei den vorangehend beschriebenen Fertigungsstufen la bis le, d.h. es werden erste und zweite Trenngräben 16 und 20 erzeugt und der erste Trenngraben wird mit einem Isolatormaterial 18 verfüllt. Im Unterschied zu der in den Fig. 1 bis Fig. 5 gezeigten Vorgehensweise des erfindungsgemäßen Verfahrens wird der zweite Trenngraben 20' der Ausführungsform gemäß Fig. 9 breiter ausgeführt als der zweite Trenngraben 20 gemäß Fig. 5. Im Falle eines ortsgenauen Verfahrens zur Aufbringung des leitfähigen Materials 26, wie beispielsweise durch ein Ink-Jet- oder Aerosoljet-Verfahren zur Verfügung gestellt, kann auch in dieser Ausführungsform der zweite Trenngraben 20' nicht breiter ausgestaltet sein als in den vorherigen Ausführungsformen gemäß Figuren 1 bis 5.

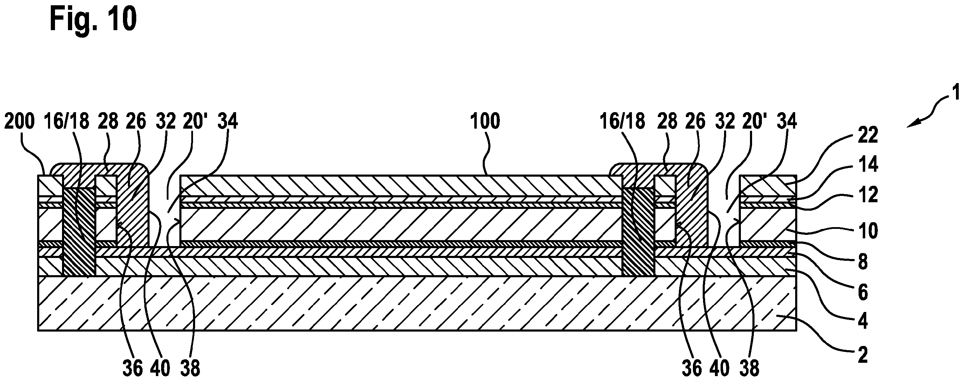

In dem sich anschließenden Verfahrensschritt wird, wie in Fig. 10 gezeigt, ein erster Volumenbereich 32 des zweiten Trenngrabens 20' mit einem aushärtbaren, leitfähigen Material 26 ortsgenau verfüllt, und zwar unter Freilassung/Auslassung des benachbarten zweiten Volumenbereichs 34. Gleichzeitig wird bei diesem Verfahrensschritt eine leitfähige Brücke 28 aus dem leitfähigen Material 26 von dem ersten Volumenbereich 32, der mit leitfähigem Material 26 ausgefüllt ist, der ersten Solarzelle 100 zu der Frontelektrodenschicht 22 der benachbarten zweiten Solarzelle 200 über den mit Isolatormaterial 18 befüllten ersten Trenngraben 16 hinweg erzeugt. Auch auf diese Weise gelingt eine Serienverschaltung von jeweils benachbarten Solarzellen des erfindungsgemäßen Dünnschichtsolarmoduls 1. Der erste Volumenbereich 32 erstreckt sich dabei von der ersten Trenngrabenwand 36, benachbart zum benachbarten ersten Trenngraben 16, bis in einen Wandungsbereich 40 des leitfähigen Materials 26 beabstandet von der gegenüberliegenden zweiten Trenngrabenwand 38 des zweiten Trenngrabens 20'. Der zweite Volumenbereich 34 erstreckt sich demgemäß von der zweiten Trenngrabenwand 38 bis zu dem Wandungsbereich 40. Beide beginnen an der Barriereschicht 6 und gehen in Querausrichtung des Dünnschichtsolarmoduls 1 bis einschließlich zur Frontelektrode 22. Ein Kontakt des ersten Volumenbereichs 32 mit der zweiten Trenngrabenwand 38 ist zur Vermeidung von Kurzschlüssen zu vermeiden.

Die in der vorstehenden Beschreibung, in den Ansprüchen sowie in den Zeichnungen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Photovoltaisches Dünnschichtsolarmodul (1), umfassend in dieser Reihenfolge, mindestens eine Substratschicht (2), mindestens eine, insbesondere an der Substratschicht unmittelbar anliegende, Rückelektrodenschicht (4), mindestens eine, insbesondere an der Rückelektrodenschicht (4) unmittelbar anliegende, leitfähige Barriereschicht (6), mindestens eine, insbesondere an der Barriereschicht (6) unmittelbar anliegende, Kontaktschicht (8), insbesondere Ohm'sche Kontaktschicht, mindestens eine, insbesondere an der Kontaktschicht (8) unmittelbar anliegende, Halbleiterabsorberschicht (10), insbesondere Chalkopyrit- oder Kesterit- Halbleiterabsorberschicht, mindestens eine transparente Frontelektrodenschicht (22), insbesondere enthaltend oder im Wesentlichen aus n-dotiertem Zinkoxid (22), **gekennzeichnet durch** beabstandete erste, mit mindestens einem Isolatormaterial (18) befüllte Strukturierungstrenngräben (16), welche benachbarte Solarzellen (100, 200) bis zur Substratschicht (2) voneinander trennen, beabstandete zweite, mit mindestens einem leitfähigen Material (26) versehene Strukturierungstrenngräben (20), welche sich bis zur Barriereschicht (6), erstrecken und jeweils benachbart zu einem befüllten ersten Strukturierungstrenngräben vorliegen, beabstandete dritte Strukturierungstrenngräben (24), welche sich bis zur Barriereschicht (6), erstrecken und jeweils benachbart zu einem zweiten Strukturierungstrenngräben (20), jenseits des ersten Strukturierungstrenngrabens (16), zu welchem der zweite Strukturierungstrenngräben (20) benachbart ist, vorliegen, und mindestens eine leitfähige Brücke (28) von mit einem leitfähigen Material (30) versehenen zweiten Strukturierungstrenngräben (20) über benachbarte erste, mit dem Isolatormaterial (18) befüllte Strukturierungstrenngräben (16) zu der Frontelektrodenschicht (22) der hierzu benachbarten Solarzelle (200).

2. Photovoltaisches Dünnschichtsolarmodul (1), umfassend in dieser Reihenfolge, mindestens eine Substratschicht (2), mindestens eine, insbesondere an der Substratschicht (2) unmittelbar anliegende, Rückelektrodenschicht (4), mindestens eine, insbesondere an der Rückelektrodenschicht (4)unmittelbar anliegende, leitfähige Barriereschicht (6), mindestens eine, insbesondere an der Barriereschicht (6) unmittelbar anliegende, Kontaktschicht (8), insbesondere Ohm'sche Kontaktschicht, mindestens eine, insbesondere an der Kontaktschicht (8) unmittelbar anliegende, Halbleiterabsorberschicht (10), insbesondere Chalkopyrit- oder Kesterit-Halbleiterabsorberschicht, und mindestens eine transparente Frontelektrodenschicht (22), insbesondere enthaltend oder im Wesentlichen aus n-dotiertem Zinkoxid, **gekennzeichnet durch** beabstandete erste, mit mindestens einem Isolatormaterial (18) befüllte Strukturierungstrenngräben (16), welche benachbarte Solarzellen (100, 200) bis zur Substratschicht (2) voneinander trennen, beabstandete vierte Strukturierungstrenngräben (20'), die sich bis zur Barriereschicht (6), erstrecken und jeweils benachbart zu einem befüllten ersten Strukturierungstrenngräben (16) vorliegen und die einen ersten Volumenbereich (32), der sich von der Barriereschicht (6) bis zur Frontelektrodenschicht (22) entlang der zum ersten Strukturierungstrenngräben (16) benachbarten Trenngrabenwand (36) erstreckt und der mit mindestens einem leitfähigen Material (26) versehen ist, und einen hierzu benachbarten zweiten Volumenbereich (34), der sich von der Barriereschicht (6) bis zur Frontelektrodenschicht (22) erstreckt, umfassen, und mindestens eine leitfähige Brücke (28) von den mit einem leitfähigen Material (26) ausgefüllten oder mit einem solchen Material versehenen ersten Volumenbereichen (32) der vierten Strukturierungstrenngräben (20') über benachbarte erste (16), mit einem Isolatormaterial (18) befüllte Strukturierungstrenngräben zu der Frontelektrodenschicht (22) der hierzu benachbarten Solarzelle (200).

3. Dünnschichtsolarmodul (1) nach Anspruch 1 oder 2, **dadurch gekennzeichnet, dass** die Halbleiterabsorberschicht (10) eine quaternäre IB-IIIA-VIA-Chalkopyritschicht, insbesondere eine Cu(ln,Ga)Se2-Schicht, eine penternäre IB-IIIA-VIAChalkopyritschicht, insbesondere eine Cu(ln,Ga)(Se1-x,Sx)2-Schicht, oder eine Kesterit-Schicht, insbesondere eine Cu2ZnSn(Sex,S1-x)4-Schicht, z.B. eine Cu2ZnSn(Se)4- oder eine Cu2ZnSn(S)4-Schicht, darstellt oder umfasst, wobei x Werte von 0 bis 1 annimmt

4. Dünnschichtsolarmodul (1) nach einem der vorangehenden Ansprüche, **dadurch gekennzeichnet, dass** das Substrat (2) eine Glasscheibe, eine Kunststoffschicht oder eine Metallplatte, insbesondere mit einer Breite größer 0,5 m, insbesondere größer 2,0 m, und einer Länge größer 1,2 m, insbesondere größer 3,0 m, darstellt.

5. Dünnschichtsolarmodul (1) nach einem der vorangehenden Ansprüche, **dadurch gekennzeichnet, dass** dië Rückelektrodenschicht (4) enthält oder im Wesentlichen gebildet ist aus V, Mn, Cr, Mo, Ti, Co, Zr, Ta, Nb und/oder W und/oder enthält oder im Wesentlichen gebildet ist aus einer Legierung enthaltend V, Mn, Cr, Mo, Ti, Co, Fe, Ni, Al, Zr, Ta, Nb und/oder W.

6. Dünnschichtsolarmodul (1) nach einem der vorangehenden Ansprüche, **dadurch gekennzeichnet, dass** die Barriereschicht (6) eine Barriere für aus der und/oder über die Rückelektrodenschicht (4) migrierende, insbesondere diffundierende bzw. diffundierbare, Komponenten und/oder für aus der und/oder über die Kontaktschicht (8) migrierende, insbesondere diffundierende bzw. diffundierbare, Komponenten, insbesondere eine bidirektionale Barriereschicht, darstellt.

7. Dünnschichtsolarmodul (1) nach einem der vorangehenden Ansprüche, **dadurch gekennzeichnet, dass** die Barriereschicht (6) eine Barriere für Alkaliionen, insbesondere Natriumionen, oder Verbindungen enthaltend Alkaliionen, Selen oder Selenverbindungen, Schwefel oder Schwefelverbindungen und/oder Metalle, insbesondere Cu, In, Ga, Fe, Ni, Ti, Zr, Hf, V, Nb, Ta, Al und/oder W, darstellt.

8. Dünnschichtsolarmodul (1) nach einem der vorangehenden Ansprüche, **dadurch gekennzeichnet, dass** die Barriereschicht (6) enthält oder im Wesentlichen gebildet ist aus mindestens einem Metallnitrid, insbesondere TiN, MoN, TaN, ZrN und/ oder WN, mindestens einem Metallcarbid, mindestens einem Metallborid und/oder mindestens einem Metallsiliziumnitrid, insbesondere TiSiN, TaSiN und/oder WSiN.

9. Dünnschichtsolarmodul (1) nach einem der vorangehenden Ansprüche, **dadurch gekennzeichnet, dass** die Kontaktschicht (8) enthält oder im Wesentlichen gebildet ist aus Mo, W, Ta, Nb, Zr und/oder Co, insbesondere Mo und/oder W, und/oder mindestens ein Metallchalkogenid enthält oder hieraus im Wesentlichen gebildet ist und/ oder mindestens eine erste Lage, benachbart zur Barriereschicht (6), enthaltend oder im Wesentlichen aus Mo, W, Ta, Nb, Zr und/oder Co, insbesondere Mo und/oder W, und mindestens eine zweite Lage, nicht benachbart zur Barriereschicht (6), enthaltend oder im Wesentlichen aus mindestens einem Metallchalkogenid, umfasst.

10. Dünnschichtsolarmodul (1) nach Anspruch 9, **dadurch gekennzeichnet, dass** das Metall des Metallchalkogenids der Kontaktschicht (8) bzw. der zweiten Lage der Kontaktschicht ausgewählt ist aus Molybdän, Wolfram, Tantal, Zirkonium, Cobalt und/oder Niob und dass das Chalkogen des Metallchalkogenids ausgewählt ist aus Selen und/oder Schwefel, wobei das Metallchalkogenid insbesondere MSe2, MS2 und/oder M(Se1-x,Sx)2 darstellt mit M = Mo, W, Ta, Zr, Co oder Nb, wobei x Werte von 0 bis 1 annimmt.

11. Dünnschichtsolarmodul (1) nach einem der Ansprüche 9 oder 10, **dadurch gekennzeichnet, dass** das Metall der ersten Lage und das Metall der zweiten Lage der Kontaktschicht (8) übereinstimmen und/oder dass das Metall der ersten Lage und/oder das Metall der zweiten Lage der Kontaktschicht (8) mit dem Metall der Rückelektrodenschicht (4) übereinstimmen und/oder dass das Metall der Kontaktschicht (8) mit dem Metall der Rückelektrodenschicht (4) übereinstimmen.

12. Dünnschichtsolarmodul (1) nach einem der vorangehenden Ansprüche, **dadurch gekennzeichnet, dass** die Halbleiterabsorberschicht (10)mindestens einen Dotierstoff, insbesondere mindestens ein Element ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod, , oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweist.

13. Dünnschichtsolarmodul (1) nach Anspruch 12, **dadurch gekennzeichnet, dass** der Dotierstoff, insbesondere Natriumionen, in der Kontaktschicht und/oder der Halbleiterabsorberschicht in einer Dosis im Bereich von 1013 bis 1017 Atomen/ cm2 insbesondere im Bereich von 1014 bis 1016 Atomen/cm2, vorliegt.

14. Photovoltaisches Dünnschichtsolarmodul (1) nach einem der vorangehenden Ansprüche, ferner umfassend mindestens eine, insbesondere an der Halbleiterabsorberschicht (10) unmittelbar anliegende, erste Pufferschicht (12), enthaltend oder im Wesentlichen aus CdS oder einer CdS-freien Schicht, insbesondere enthaltend oder im Wesentlichen aus Zn(S,OH) oder ln2S3, und/oder mindestens eine, insbesondere an der Halbleiterabsorberschicht (10) oder der ersten Pufferschicht (12) unmittelbar anliegende, zweite Pufferschicht (14), enthaltend und im Wesentlichen aus intrinsischem Zinkoxid und/oder hochohmigem Zinkoxid, insbesondere wobei die transparente Frontelektrodenschicht (22)an der Halbleiterabsorberschicht (10), der ersten Pufferschicht (12) und/oder der zweiten Pufferschicht (14) unmittelbar anliegt

15. Dünnschichtsolarmodul (1) nach einem der vorangehenden Ansprüche, **dadurch gekennzeichnet, dass** die durchschnittliche Dicke der Rückelektrodenschicht (4) im Bereich von 50 nm bis 500 nm, insbesondere im Bereich von 80 nm bis 250 nm, und/oder die der Barriereschicht (6) im Bereich von 10 nm bis 250 nm, insbesondere im Bereich von 20 nm bis 150 nm, und/oder die der Kontaktschicht (8) im Bereich von 2 nm bis 200 nm, insbesondere im Bereich von 5 nm bis 100 nm, und/oder die der Halbleiterabsorberschicht (10) im Bereich von 400 nm bis 2500 nm, insbesondere im Bereich von 500 nm bis 2000 nm und vorzugsweise im Bereich von 800 nm bis 1600 nm, und/oder die der ersten Pufferschicht (12) im Bereich von 5 nm bis 100 nm, insbesondere im Bereich von 10 nm bis 70 nm, und/oder die der zweiten Pufferschicht (14) im Bereich von 10 nm bis 150 nm, insbesondere im Bereich von 20 nm bis 100 nm, liegt.

16. Dünnschichtsolarmodul (1) nach einem der vorangehenden Ansprüche, **dadurch gekennzeichnet, dass** die Rückelektrodenschicht (4) Molydän und/oder Wolfram, insbesondere Molybdän, enthält oder im Wesentlichen aus Molydän und/oder Wolfram, insbesondere Molybdän, gebildet ist, die leitfähige Barriereschicht (6) TiN enthält oder im Wesentlichen aus TiN gebildet ist, und die Kontaktschicht (8) MoSe2 enthält oder im Wesentlichen aus MoSe2 gebildet ist.

17. Dünnschichtsolarmodul (1) nach einem der vorangehenden Ansprüche, **dadurch gekennzeichnet, dass** die ersten (16), zweiten (20), dritten (24) und/oder vierten (20') Strukturierungstrenngräben mindestens abschnittsweise, insbesondere vollständig, eine durchschnittliche Breite von nicht mehr als 50 µm, insbesondere von nicht mehr als 30 µm und vorzugsweise von nicht mehr als 15 µm, aufweisen.

18. Dünnschichtsolarmodul (1) nach einem der vorangehenden Ansprüche, **dadurch gekennzeichnet, dass**, insbesondere benachbarte, erste (16) und zweite (20) und/oder, insbesondere benachbarte, erste (16) und dritte (24) und/oder, insbesondere benachbarte, zweite (20) und dritte (24) Strukturierungstrenngräben, oder, insbesondere benachbarte, erste (16), zweite (20) und dritte (24) Strukturierungstrenngräben oder, insbesondere benachbarte, erste (16) und vierte (20') Strukturierungstrenngräben mindestens abschnittsweise im Wesentlichen parallel verlaufen.

19. Dünnschichtsolarmodul (1) nach einem der vorangehenden Ansprüche, **dadurch gekennzeichnet, dass** benachbarte erste Strukturierungstrenngräben (16) und/ oder benachbarte zweite Strukturierungstrenngräben (20) und/oder benachbarte dritte Strukturierungstrenngräben (24) und/oder benachbarte vierte Strukturierungstrenngräben (20') mindestens abschnittsweise einen durchschnittlichen Abstand im Bereich von 3 mm bis 10 mm, insbesondere von 4 mm bis 8 mm, aufweisen.

20. Dünnschichtsolarmodul (1) nach einem der vorangehenden Ansprüche, **dadurch gekennzeichnet, dass** benachbarte erste (16) und zweite (20) Strukturierungstrenngräben und/oder benachbarte zweite (20) und dritte Strukturierungstrenngräben (24)und/oder benachbarte erste (16) und vierte (20') Strukturierungstrenngräben mindestens abschnittsweise, insbesondere vollständig, einen durchschnittlichen Abstand im Bereich von 5 µm bis 100 µm, insbesondere im Bereich von 10 µm bis 50 µm, aufweisen.

21. Dünnschichtsolarmodul (1) nach einem der vorangehenden Ansprüche, **dadurch gekennzeichnet, dass** die ersten Strukturierungstrenngräben (16) mit dem Isolator (18) über das Niveau der Kontaktschicht (8), insbesondere über das Niveau der Halbleiterabsorberschicht, hinaus mit dem Isolator (18) befüllt sind und/oder dass der Brückenwiderstand über den mit Isolator (18) befüllten ersten Strukturierungstrenngräben (16) größer 50 kOhm, insbesondere größer 100 kOhm, ist.

22. Dünnschichtsolarmodul nach einem der vorangehenden Ansprüche, **gekennzeichnet durch** mindestens zwei, insbesondere eine Vielzahl an, monolithisch integriert serienverschalteten Solarzellen.

23. Verfahren zur Herstellung eines Dünnschichtsolarmoduls (1) nach einem der Ansprüche 1 und 3 bis 22, soweit diese direkt oder indirekt auf den Anspruch 1 rückbezogen sind, umfassend: a) Zurverfügungstellung einer, insbesondere flächigen, Substratschicht (2), b) Aufbringen mindestens einer Rückelektrodenschicht (4), insbesondere auf der Substratschicht (2), c) Aufbringen mindestens einer leitfähigen Barriereschicht (6), insbesondere auf der der Rückelektrodenschicht (4) oder auf der Substratschicht (2) und auf der Rückelektrodenschicht (4), insbesondere auf der Rückelektrodenschicht (4), welche unmittelbar auf der Substratschicht (2) angebracht worden ist, d) Aufbringen mindestens einer, insbesondere Ohm'schen, Kontaktschicht (8), insbesondere auf der Barriereschicht (6), e) Aufbringen mindestens einer, insbesondere Kesterit- oder Chalkopyrit-, Halbleiterabsorberschicht (10), insbesondere auf der Kontaktschicht (8) h) Aufbringen mindestens einer transparenten Frontelektrodenschicht (22), insbesondere auf der Halbleiterabsorberschicht (10) oder der ersten (12) oder zweiten (14) Pufferschicht, i) mindestens einen ersten Strukturierungsschritt, umfassend Entfernen der auf die Substratschicht (2) aufgebrachten Schichten (4,6,8,10,12,14,22) entlang voneinander beabstandeter Linien mittels Laserbehandlung (erste Laserbehandlung) unter Ausbildung erster Strukturierungstrenngräben (16), welche benachbarte Solarzellen (100, 200) trennen, j) mindestens einen zweiten Strukturierungsschritt, umfassend j1) Entfernen derjenigen Schichten, die von der Barriereschicht (6) bis einschließlich zu der Frontelektrodenschicht (22) erstrecken, entlang voneinander beabstandeter Linien unter Ausbildung zweiter Strukturierungstrenngräben (20), welche zu ersten Strukturierungstrenngräben (16) benachbart sind oder an diese angrenzen und insbesondere mindestens abschnittsweise im Wesentlichen parallel zu diesen verlaufen, oder j2) chemische Phasenumwandlung und/oder thermischer Zersetzung derjenigen Schichten, die sich von der Barriereschicht (6), bis einschließlich zu der Frontelektrodenschicht (22) erstrecken, entlang voneinander beabstandeter Linien unter Ausbildung erster linienförmiger leitfähiger Bereiche (30), welche zu ersten Strukturierungstrenngräben (16) benachbart sind oder an diese angrenzen und insbesondere mindestens abschnittsweise im Wesentlichen parallel zu diesen verlaufen, k) mindestens einen dritten Strukturierungsschritt, umfassend Entfernen der Schichten, die sich von der Barriereschicht (6), bis einschließlich zu der Frontelektrodenschicht (22) erstrecken, entlang voneinander beabstandeter Linien unter Ausbildung dritter Strukturierungstrenngräben (24), welche zu zweiten Strukturierungstrenngräben (20) benachbart sind oder an diese angrenzen und insbesondere abschnittsweise im Wesentlichen parallel zu diesen verlaufen, I) Füllen der ersten Strukturierungstrenngräben (16) mit mindestens einem Isolatormaterial (18), m) Füllen der zweiten Strukturierungstrenngräben (20) mit mindestens einem leitfähigen Material (26), n) Ausbilden mindestens einer leitfähigen Bücke (28) mit einem leitfähigen Material (26) von den mit leitfähigem Material befullten zweiten Strukturierungstrenngräben (20) oder den ersten linienförmigen leitfähigen Bereichen (30) über benachbarte erste, mit dem Isolatormaterial (18) befüllte Strukturierungstrenngräben (16) zu der Frontelektrodenschicht (22) der hierzu benachbarten Solarzelle (200), so dass benachbarte Solarzellen (200,100) elektrisch serienverschaltet werden.

24. Verfahren zur Herstellung eines Dünnschichtsolarmoduls (1) nach einem der Ansprüche 2 bis 22, umfassend: a) Zurverfügungstellung einer, insbesondere flächigen, Substratschicht (2), b) Aufbringen mindestens einer Rückelektrodenschicht (4), insbesondere auf der Substratschicht (2), c) Aufbringen mindestens einer leitfähigen Barriereschicht (6), insbesondere auf der Substratschicht (2) oder auf der Rückelektrodenschicht (4) oder auf der Substratschicht (2) und auf der Rückelektrodenschicht (4), insbesondere auf der Rückelektrodenschicht (4), welche unmittelbar auf die Substratschicht (2) aufgebracht worden ist, d) Aufbringen mindestens einer, insbesondere Ohm'schen, Kontaktschicht (8), insbesondere auf der Barriereschicht (6), e) Aufbringen mindestens einer, insbesondere Kesterit- oder Chalkopyrit-, Halbleiterabsorberschicht (10), insbesondere auf der Kontaktschicht (8), h) Aufbringen mindestens einer transparenten Frontelektrodenschicht (22), insbesondere auf der Halbleiterabsorberschicht (10) oder auf der ersten (12) oder zweiten Pufferschicht (14), i) mindestens einen ersten Strukturierungsschritt, umfassend Entfernen der auf die Substratschicht (2) aufgebrachten Schichten entlang voneinander beabstandeter Linien mittels Laserbehandlung (erste Laserbehandlung) unter Ausbildung erster Strukturierungstrenngräben (16), welche benachbarte Solarzellen (100, 200) trennen, o) mindestens einen vierten Strukturierungsschritt, umfassend Entfernen derjenigen Schichten, die sich von der Barriereschicht (6), bis einschließlich zu der Frontelektrodenschicht (22) erstrecken, entlang von einander beabstandeter Linien unter Ausbildung vierter Strukturierungstrenngräben (20'), welche zu ersten Strukturierungstrenngräben (16) benachbart sind oder an diese angrenzen und insbesondere mindestens abschnittsweise im Wesentlichen parallel zu diesen verlaufen, p) Füllen der ersten Strukturierungstrenngräben (16) mit mindestens einem Isolatormaterial (18), q) Füllen eines ersten Volumenbereichs (32) der vierten Strukturierungstrenngräben (20'), der sich von der Barriereschicht (6), bis zur Frontelektrodenschicht (22) entlang der zum ersten Strukturierungstrenngräben (16) benachbarten Trenngrabenwand (36) erstreckt mit mindestens einem leitfähigen Material (26), unter Nichtbefüllung/ Freilassung eines hierzu benachbarten zweiten Volumenbereich (34), der sich von der Barriereschicht (6) bis zur Frontelektrodenschicht (22) entlang derjenigen Trenngrabenwand (38) erstreckt, die nicht zum ersten Strukturierungstrenngräben (16) benachbart ist, r) Ausbilden mindestens einer leitfähigen Brücke (28) mit einem leitfähigen Material (26) von den mit leitfähigem Material (26) befüllten ersten Volumenbereichen (32) der vierten Strukturierungstrenngräben (20') über benachbarte erste (16), mit dem Isolatormaterial (18) befüllte Strukturierungstrenngräben zu der Frontelektrodenschicht (22) der hierzu benachbarten Solarzelle (200), so dass benachbarte Solarzellen elektrisch serienverschaltet werden.

25. Verfahren nach Anspruch 23, **dadurch gekennzeichnet, dass** die Schritte m) und n) zu einem Schritt s) zusammengefasst sind.

26. Verfahren nach Anspruch 23 oder 25, **dadurch gekennzeichnet, dass** die Reihenfolge der Schritte i), j1), k), l) und m) beliebig ist, solange I), unmittelbar oder mittelbar, nach i) kommt und m), unmittelbar oder mittelbar, nach j1) kommt, insbesondere die Abfolge i), j1), l), k), m) und n) oder i), j1), l), k) und s), umfasst, oder dass die Reihenfolge der Schritte i), j2), k) und l) beliebig ist, solange I), unmittelbar oder mittelbar, nach i) kommt, insbesondere die Abfolge i), j2), l), k) und n) umfasst.

27. Verfahren nach Anspruch 24, **dadurch gekennzeichnet, dass** die Schritte q) und r) zu einem Schritt t) zusammengefasst sind.

28. Verfahren nach Anspruch 24 oder 27, **dadurch gekennzeichnet, dass** die Reihenfolge der Schritte i), o), p) und q) beliebig ist, solange p), unmittelbar oder mittelbar, nach i) kommt und q), unmittelbar oder mittelbar, nach o) kommt, insbesondere die Abfolge i), o), p), q) und r) oder i), o), p) und t) umfasst.

29. Verfahren nach einem der Ansprüche 23 bis 28, **dadurch gekennzeichnet, dass** das Substrat (2) zumindest bereichsweise für elektromagnetische Strahlung der ersten Laserbehandlung durchlässig ist und/oder dass die Laserbehandlung des ersten Strukturierungsschritts, insbesondere durch Laserablation, von der der beschichteten Seite des Substrats (2) abgewandten Seite erfolgt.

30. Verfahren nach einem der Ansprüche 23 bis 29, **dadurch gekennzeichnet, dass** in dem zweiten und/oder dritten und/oder vierten, insbesondere dem zweiten, Strukturierungsschritt die zweiten (20), dritten (24) bzw. vierten (20') Strukturierungstrenngräben mittels Laserbehandlung (zweite, dritte bzw. vierte Laserbehandlung) erzeugt werden und/ oder dass in dem zweiten und/oder dritten und/oder vierten, insbesondere dem dritten und/oder vierten, Strukturierungsschritt die zweiten (20), dritten (24) bzw. vierten (20') Strukturierungstrenngräben mechanisch, insbesondere mittels Nadelritzens, erzeugt werden.

31. Verfahren nach einem der Ansprüche 23 bis 30, **dadurch gekennzeichnet, dass** die ersten (16), zweiten (20), dritten (24) und/oder vierten (20') Strukturierungstrenngräben und/oder die ersten linienförmigen leitfähigen Bereiche (30) mindestens abschnittsweise, insbesondere vollständig, mit einer durchschnittlichen Breite von nicht mehr als 50 µm, insbesondere von nicht mehr als 30 µm und vorzugsweise von nicht mehr als 15 µm, erzeugt werden.

32. Verfahren nach einem der Ansprüche 23 bis 31, **dadurch gekennzeichnet, dass**, insbesondere benachbarte, erste (16) und zweite (20) und/oder, insbesondere benachbarte, erste (16) und dritte (24) und/oder, insbesondere benachbarte, zweite (20) und dritte (24) Strukturierungstrenngräben, oder, insbesondere benachbarte,
erste (16), zweite (20) und dritte (24) Strukturierungstrenngräben oder, insbesondere benachbarte, erste (16) und vierte (20') Strukturierungstrenngräben oder, insbesondere benachbarte, erste Strukturierungstrenngräben (16) und erste linienförmige leitfähige Bereiche (30) mindestens abschnittsweise im Wesentlichen parallel geführt werden.

33. Verfahren nach einem der Ansprüche 23 bis 32, **dadurch gekennzeichnet, dass** benachbarte erste Strukturierungstrenngräben (16) und/oder benachbarte zweite Strukturierungstrenngräben (20) und/oder benachbarte dritte Strukturierungstrenngräben (24) und/oder benachbarte vierte Strukturierungstrenngräben (20') und/oder benachbarte erste linienförmige leitfähige Bereiche (30)mindestens abschnittsweise in einem durchschnittlichen Abstand von im Bereich von 3 mm bis 10 mm, insbesondere von 4 mm bis 8 mm, erzeugt werden.

34. Verfahren nach einem der Ansprüche 23 bis 33, **dadurch gekennzeichnet, dass** benachbarte erste (16) und zweite (20) Strukturierungstrenngräben und/oder benachbarte zweite (20) und dritte (24) Strukturierungstrenngräben und/oder benachbarte erste (16) und vierte (20') Strukturierungstrenngräben und/oder benachbarte erste Strukturierungstrenngräben (16) und erste linienförmige leitfähige Bereiche (30) mindestens abschnittsweise, insbesondere vollständig, in einem durchschnittlichen Abstand im Bereich von 5 µm bis 100 µm, insbesondere im Bereich von 10 µm bis 50 µm, erzeugt werden.

35. Verfahren nach einem der Ansprüche 23 bis 34, **dadurch gekennzeichnet, dass** benachbarte erste (16), zweite (20) und dritte (24) oder benachbarte erste (16) und vierte (20') Strukturierungstrenngräben oder benachbarte erste Strukturierungstrenngräben (16) und erste linienförmige leitfähige Bereiche (30) einen geringeren durchschnittlichen Abstand zueinander aufweisen als nicht benachbarte erste (16), zweite (20) und dritte (24) bzw. nicht benachbarte erste (16) und vierte Strukturierungstrenngräben (20') oder nicht benachbarte erste Strukturierungstrenngräben (16) und erste linienförmige leitfähige Bereiche (30).

36. Verfahren nach einem der Ansprüche 23 bis 35, **dadurch gekennzeichnet, dass** dritte Strukturierungstrenngräben (24), insbesondere sämtliche dritten Strukturierungstrenngräben (24), durch den jeweils benachbarten zweiten Strukturierungstrenngräben (20) oder den ersten linienförmigen leitfähigen Bereich (30) von dem jeweils benachbarten ersten Strukturierungstrenngräben (16) separiert sind.

37. Verfahren nach einem der Ansprüche 23 bis 36, **dadurch gekennzeichnet, dass** die, insbesondere mindestens einen Dotierstoff enthaltende, Kontaktschicht (8) enthält oder im Wesentlichen gebildet ist aus Molybdän, Tantal, Zirkonium, Cobalt, Niob und/oder Wolfram (erste Metalllage) und/oder mindestens einem Metallchalkogenid ausgewählt aus Metallselenid, Metallsulfid und/oder Metallsulfoselenid mit Metall = Mo, W, Ta, Zr, Co oder Niob, insbesondere ausgewählt aus der Gruppe bestehend aus MoSe2, WSe2, MoS2, WS2, Mo(Se1-x,Sx) 2 und/oder W(Se1 -x,Sx) 2, wobei x Werte von 0 bis 1 annimmt.

38. Verfahren nach einem der Ansprüche 23 bis 37, **dadurch gekennzeichnet, dass** die Halbleiterabsorberschicht (10) eine quaternäre IB-IIIA-VIA-Chalkopyritschicht, insbesondere eine Cu(ln,Ga)Se2-Schicht, eine penternäre IB-IIIA-VIAChalkopyritschicht, insbesondere eine Cu(ln,Ga)(Se1-x,Sx)2-Schicht, oder eine Kesterit-Schicht, insbesondere eine Cu2ZnSn(Sex,S1-x)4-Schicht, z.B. eine Cu2ZnSn(Se)4- oder eine Cu2ZnSn(S)4-Schicht, darstellt oder umfasst, wobei x Werte von 0 bis 1 annimmt.

39. Verfahren nach einem der Ansprüche 23 bis 38, **dadurch gekennzeichnet, dass** durch das Aufbringen der Kesterit- oder Chalkopyrit-Halbleiterabsorberschicht (10) auf der Kontaktschicht (8) in der Kontaktschicht vorliegende Metalle oder diese Kontaktschicht bildende Metalle vollständig oder partiell zu Metallseleniden, Metallsulfiden und/oder Metallsulfoseleniden umgewandelt werden.

40. Verfahren nach einem der Ansprüche 23 bis 39, **dadurch gekennzeichnet, dass** die erste Laserbehandlung, die zweite Laserbehandlung und/oder die dritte Laserbehandlung mit Laserlichtpulsen mit einer Pulsdauer im Bereich von 1 pico-Sekunden bis 1 nano-Sekunde erfolgen.

41. Verfahren nach einem der Ansprüche 23 bis 40, **dadurch gekennzeichnet, dass** der erste, zweite und dritte Strukturierungsschritt oder der erste und vierte Strukturierungsschritt zu einer monolithisch integrierten Serienverschaltung der Solarzellen (100, 200) führen oder beitragen und insbesondere als linienhafte Prozessierschritte ausgestaltet sind.

42. Verfahren nach einem der Ansprüche 23 bis 41, **dadurch gekennzeichnet, dass** der Schritt des Aufbringens der Halbleiterabsorberschicht (10), insbesondere der Kesterit- oder Chalkopyrit-Halbleiterabsorberschicht, umfasst: die Abscheidung von, insbesondere sämtlichen, metallischen Komponenten der Halbleiterabsorberschicht, insbesondere von Kupfer, Indium und gegebenenfalls Gallium ˙fur die Chalkopyrit- Halbleiterabsorberschicht und Kupfer, Zink und Zinn ˙fur die Kesterit-Halbleiterabsorberschicht, auf der Kontaktschicht unter Ausbildung einer zweiten Metalllage und das Behandeln dieser zweiten Metalllage mit Selen und/oder einer Selenverbindung sowie gegebenenfalls mit Schwefel und/oder einer Schwefelverbindung.

43. Verfahren nach einem der Ansprüche 23 bis 42, ferner umfassend zwischen den Schritten e) und h) die nachfolgenden Schritte f) und/oder g), insbesondere in dieser Reihenfolge, f) Aufbringen mindestens einer ersten Pufferschicht (12), insbesondere auf der Halbleiterabsorberschicht (10), g) Aufbringen mindestens einer zweiten Pufferschicht (14), insbesondere auf der ersten Pufferschicht (12) oder der Halbleiterabsorberschicht (10), insbesondere wobei in Schritt h) die mindestens eine transparente Frontelektrodenschicht (22) auf der Halbleiterabsorberschicht (10) oder auf der ersten (12) oder zweiten (14) Pufferschicht aufgebracht wird.

44. Verfahren nach einem der Ansprüche 23 bis 43, **dadurch gekennzeichnet, dass** die Rückelektrodenschicht (4), die leitfähige Barriereschicht (6), die erste Metalllage, insbesondere enthaltend Mo, die Kontaktschicht (8), die zweite Metalllage, insbesondere enthaltend Cu, In und Ga, die erste Pufferschicht (12), die zweite Pufferschicht (14) und/oder die Frontelektrodenschicht (22) erhalten werden mittels physikalischer Gasphasenabscheidung, insbesondere umfassend Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mitttles chemischer Gasphasenabscheidung, insbesondere umfassend Chemical Vapour Deposition (CVD), Niedrigdruck- (low pressure) CVD und/oder Atmosphären- (atmospheric pressure) CVD.

45. Verfahren nach einem der Ansprüche 23 bis 44, **dadurch gekennzeichnet, dass** das Aufbringen der Rückelektrodenschicht (4), der leitfähigen Barriereschicht (6), der ersten Metalllage oder der Kontaktschicht (8) und der zweiten Metalllage in einer einzigen Vakuum-Beschichtungsanlage, vorzugsweise im Durchlauf-Sputterverfahren, erfolgen.

46. Verfahren nach einem der Ansprüche 23 bis 45, **dadurch gekennzeichnet, dass** der erste und der zweite Strukturierungsschritt und der Schritt des Verfüllens des ersten Strukturierungstrenngrabens (16) mit dem Isolatormaterial (18) in einer einzigen Anlage erfolgen.

47. Verfahren nach einem der Ansprüche 23 bis 46, **dadurch gekennzeichnet, dass** das Verfüllen des ersten Strukturierungstrenngrabens (16) mit dem Isolatormaterial (18) und/oder das Verfüllen des zweiten Strukturierungsgraturierungstrenngrabens (20) oder des ersten Volumenbereichs (32) des vierten Strukturierungstrenngrabens (20') mit dem leitfähigen Material (26) mit dem Ink-Jet-Verfahren oder mit dem Aerosoljet-Verfahren erfolgt.

## Claims

1. A photovoltaic thin-film solar module (1), comprising in this order: at least one substrate layer (2), at least one rear electrode layer (4) lying in particular immediately in contact with the substrate layer, at least one conductive barrier layer (6) lying in particular immediately in contact with the rear electrode layer (4), at least one contact layer (8) lying in particular immediately in contact with the barrier layer (6), in particular an ohmic contact layer, at least one semiconductor absorber layer (10) in particular lying immediately in contact with the contact layer (8), in particular a chalcopyrite or kesterite semiconductor absorber layer, at least one transparent front electrode layer (22), in particular containing or substantially made of n-doped zinc oxide (22), **characterized by** spaced first structuring separation trenches (16) filled with at least one insulator material (18), which separate adjacent solar cells (100, 200) up to the substrate layer (2) from each other, spaced second structuring separation trenches (20) provided with at least one conductive material (26), which extend up to the barrier layer (6) and are respectively provided adjacent to a filled first structuring separation trench, spaced third structuring separation trenches (24) which extend up to the barrier layer (6) and which are respectively provided adjacent to a second structuring separation trench (20) on the other side of the first structuring separation trench (16), to which the second structuring separation trench (20) is adjacent, and at least one conductive bridge (28) from second structuring separation trenches (20) provided with a conductive material (30) to adjacent first structuring separation trenches (16) filled with the insulator material (18) to the front electrode layer (22) of the solar cell (200) adjacent hereto.

2. A photovoltaic thin-film solar module (1), comprising in this order: at least one substrate layer (2), at least one rear electrode layer (4) lying in particular immediately in contact with the substrate layer (2), at least one conductive barrier layer (6) lying in particular immediately in contact with the rear electrode layer (4), at least one contact layer (8) lying in particular immediately in contact with the barrier layer (6), in particular an ohmic contact layer, at least one semiconductor absorber layer (10) lying in particular immediately in contact with the contact layer (8), in particular a chalcopyrite or kesterite semiconductor absorber layer, and at least one transparent front electrode layer (22) in particular containing or substantially made of n-doped zinc oxide, **characterized by** spaced first structuring separation trenches (16) filled with at least one insulator material (18), which separate adjacent solar cells (100, 200) up to the substrate layer (2) from each other, spaced fourth structuring separation trenches (20') which extend up to the barrier layer (6) and which are respectively provided adjacent to a filled first structuring separation trench (16) and which comprise a first volume region (32) which extends from the barrier layer (6) up to the front electrode layer (22) along the separation trench wall (36) adjacent to the first structuring separation trench (16) and which is provided with at least one conductive material (26), and a second volume region (34) adjacent hereto, which extends from the barrier layer (6) up to the front electrode layer (22), and at least one conductive bridge (28) from the first volume regions (32) of the fourth structuring separation trenches (20') filled with a conductive material (26) or provided with such a material to adjacent first (16) structuring separation trenches filled with an insulator material (18) to the front electrode layer (22) of the solar cell (200) adjacent hereto.

3. The thin-film solar module (1) according to Claim 1 or 2, **characterized in that** the semiconductor absorber layer (10) constitutes or comprises a quaternary IB-IIIA-VIA chalcopyrite layer, in particular a Cu(ln,Ga)Se2 layer, a penternary IB-IIIA-VIA chalcopyrite layer, in particular a Cu(ln,Ga)(Se₁₋ₓ,Sx)₂ layer, or a kesterite layer, in particular a Cu₂ZnSn(Seₓ,S₁₋ₓ)₄ layer, e.g. a Cu₂ZnSn(Se)₄ or a Cu₂ZnSn(S)₄ layer, wherein x assumes values from 0 to 1

4. The thin-film solar module (1) according to any one of the preceding claims, **characterized in that** the substrate (2) constitutes a glass disk, a plastic layer or a metal plate, in particular having a width greater than 0.5 m, in particular greater than 2.0 m, and a length greater than 1.2m, in particular greater than 3.0 m.

5. The thin-film solar module (1) according to any one of the preceding claims, **characterized in that** the rear electrode layer (4) contains or is substantially formed from V, Mn, Cr, Mo, Ti, Co, Zr, Ta, Nb and/or W and/or contains or is substantially formed from an alloy containing V, Mn, Cr, Mo, Ti, Co, Fe, Ni, Al, Zr, Ta, Nb and/or W.

6. The thin-film solar module (1) according to any one of the preceding claims, **characterized in that** the barrier layer (6) constitutes a barrier to components migrating, in particular diffusing or respectively which can diffuse from the and/or via the rear electrode layer (4), and/or to components migrating, in particular diffusing or respectively which can diffuse from the and/or via the contact layer (8), in particular a bidirectional barrier layer.

7. The thin-film solar module (1) according to any one of the preceding claims, **characterized in that** the barrier layer (6) constitutes a barrier to alkali ions, in particular sodium ions, or compounds containing alkali ions, selenium or selenium compounds, sulfur or sulfur compounds and/or metals, in particular Cu, In, Ga, Fe, Ni, Ti, Zr, Hf, V, Nb, Ta, Al and/or W.

8. The thin-film solar module (1) according to any one of the preceding claims, **characterized in that** the barrier layer (6) contains or is substantially formed from at least one metal nitride, in particular TiN, MoN, TaN, ZrN and/or WN, at least one metal carbide, at least one metal boride and/or at least one metal silicon nitride, in particular TiSiN, TaSiN and/or WSiN.

9. The thin-film solar module (1) according to any one of the preceding claims, **characterized in that** the contact layer (8) contains or is substantially formed from Mo, W, Ta, Nb, Zr and/or Co, in particular Mo and/or W, and/or contains at least one metal chalcogenide or is substantially formed herefrom, and/or comprises at least one first layer, adjacent to the barrier layer (6), containing or substantially made of Mo, W, Ta, Nb, Zr and/or Co, in particular Mo and/or W, and at least one second layer, not adjacent to the barrier layer (6), containing or substantially made of at least one metal chalcogenide.

10. The thin-film solar module (1) according to Claim 9, **characterized in that** the metal of the metal chalcogenide of the contact layer (8) or respectively of the second layer of the contact layer is selected from molybdenum, tungsten, tantalum, zirconium, cobalt and/or niobium and the chalcogen of the metal chalcogenide is selected from selenium and/or sulfur, wherein the metal chalcogenide in particular constitutes MSe₂, MS₂ and/or M(Se₁₋ₓ,Sₓ)₂, where M = Mo, W, Ta, Zr, Co or Nb, wherein x assumes values from 0 to 1.

11. The thin-film solar module (1) according to any one of Claims 9 or 10, **characterized in that** the metal of the first layer and the metal of the second layer of the contact layer (8) coincide and/or the metal of the first layer and/or the metal of the second layer of the contact layer (8) coincide with the metal of the rear electrode layer (4), and/or the metal of the contact layer (8) coincides with the metal of the rear electrode layer (4).

12. The thin-film solar module (1) according to any one of the preceding claims, **characterized in that** the semiconductor absorber layer (10) has at least one dopant, in particular at least one element selected from the group of sodium, potassium and lithium and/or at least one compound of these elements, preferably with oxygen, selenium, sulfur, boron and/or halogens, e.g. iodine, or fluorine, and/or at least one alkali metal bronze, in particular sodium and/or potassium bronze, preferably with a metal selected from molybdenum, tungsten, tantalum and/or niobium.

13. The thin-film solar module (1) according to Claim 12, **characterized in that** the dopant, in particular sodium ions, in the contact layer and/or the semiconductor absorber layer is present in a dose in the range of 1013 to 1017 atoms/cm², in particular in the range of 1014 to 1016 atoms/cm².

14. The photovoltaic thin-film solar module (1) according to any one of the preceding claims, further comprising at least one first buffer layer (12) lying in particular immediately in contact with the semiconductor absorber layer (10), containing or substantially made of CdS or a CdS-free layer, in particular containing or substantially made of Zn(S,OH) or In₂S₃, and/or at least one second buffer layer (14) lying in particular immediately in contact with the semiconductor absorber layer (10) or the first buffer layer (14), containing and substantially made of intrinsic zinc oxide and/or high-ohmic zinc oxide, in particular wherein the transparent front electrode layer (22) lies immediately in contact with the semiconductor absorber layer (10), the first buffer layer (12) and/or the second buffer layer (14).

15. The thin-film solar module (1) according to any one of the preceding claims, **characterized in that** the average thickness of the rear electrode layer (4) is in the range of 50 nm to 500 nm, in particular in the range of 80 nm to 250 nm, and/or of the barrier layer (6) is in the range of 10 nm to 250 nm, in particular in the range of 20 nm to 150 nm, and/or of the contact layer (8) is in the range of 2 nm to 200 nm, in particular in the range of 5 nm to 100 nm, and/or of the semiconductor absorber layer (10) is in the range of 400 nm to 2500 nm, in particular in the range of 500 nm to 2000 nm and preferably in the range of 800 nm to 1600 nm, and/or of the first buffer layer (12) is in the range of 5 nm to 100 nm, in particular in the range of 10 nm to 70 nm, and/or of the second buffer layer (14) is in the range of 10 nm to 150 nm, in particular in the range of 20 nm to 100 nm.

16. The thin-film solar module (1) according to any one of the preceding claims, **characterized in that** the rear electrode layer (4) contains molybdenum and/or tungsten, in particular molybdenum, or is substantially formed from molybdenum and/or tungsten, in particular molybdenum, the conductive barrier layer (6) contains TiN or is substantially formed from TiN, and the contact layer (8) contains MoSe₂ or is substantially formed from MoSe₂.

17. The thin-film solar module (1) according to any one of the preceding claims, **characterized in that** the first (16), second (20), third (24) and/or fourth (20') structuring separation trenches have, at least in sections, in particular completely, an average width of not more than 50 µm, in particular of not more than 30 µm and preferably of not more than 15 µm.

18. The thin-film solar module (1) according to any one of the preceding claims, **characterized in that**, in particular adjacent, first (16) and second (20) and/or, in particular adjacent, first (16) and third (24) and/or, in particular adjacent, second (20) and third (24) structuring separation trenches or, in particular adjacent, first (16), second (20) and third (24) structuring separation trenches or, in particular adjacent, first (16) and fourth (20') structuring separation trenches run at least in sections substantially parallel.

19. The thin-film solar module (1) according to any one of the preceding claims, **characterized in that** adjacent first structuring separation trenches (16) and/or adjacent second structuring separation trenches (20) and/or adjacent third structuring separation trenches (24) and/or adjacent fourth structuring separation trenches (20') have at least in sections an average distance in the range of 3 mm to 10 mm, in particular of 4 mm to 8 mm.

20. The thin-film solar module (1) according to any one of the preceding claims, **characterized in that** adjacent first (16) and second (20) structuring separation trenches and/or adjacent second (20) and third structuring separation trenches (24) and/or adjacent first (16) and fourth (20') structuring separation trenches have at least in sections, in particular completely, an average distance in the range of 5 µm to 100 µm, in particular in the range of 10 µm to 50 µm.

21. The thin-film solar module (1) according to any one of the preceding claims, **characterized in that** the first structuring separation trenches (16) are filled with the insulation (18) above the level of the contact layer (8), in particular filled with the insulation (18) beyond the level of the semiconductor absorber layer, and/or the bridge resistance above the first structuring separation trench (16) filled with insulation (18) is greater than 50 kOhm, in particular greater than 100 kOhm.

22. The thin-film solar module according to any one of the preceding claims, **characterized by** at least two, in particular a plurality of, monolithically integrated series-connected solar cells.

23. The method for producing a thin-film solar module (1) according to any one of Claims 1 and 3 to 22, inasmuch as these refer back directly or indirectly to Claim 1, comprising: a) supplying an in particular planar substrate layer (2), b) applying at least one rear electrode layer (4), in particular to the substrate layer (2), c) applying at least one conductive barrier layer (6), in particular to the rear electrode layer (4) or to the substrate layer (2) and to the rear electrode layer (4), in particular to the rear electrode layer (4) which has been directly applied to the substrate layer (2), d) applying at least one, in particular ohmic, contact layer (8), in particular to the barrier layer (6), e) applying at least one, in particular kesterite or chalcopyrite, semiconductor absorber layer (10), in particular to the contact layer (8) h) applying at least one transparent front electrode layer (22), in particular to the semiconductor absorber layer (10) or the first (12) or second (14) buffer layer, i) at least one first structuring step, comprising removing the layers (4,6,8,10,12,14,22) applied to the substrate layer (2) along lines spaced apart from each other by means of laser treatment (first laser treatment), configuring first structuring separation trenches (16) which separate adjacent solar cells (100, 200), j) at least one second structuring step, comprising j1) removing those layers which extend from the barrier layer (6) up to and including the front electrode layer (22), along lines spaced apart from each other, configuring second structuring separation trenches (20) which are adjacent to first structuring separation trenches (16) or adjoin these and in particular run at least in sections substantially parallel to these, or j2) chemical phase transformation and/or thermal decomposition of those layers which extend from the barrier layer (6) up to and including the front electrode layer (22) along lines spaced apart from each other, configuring first linear conductive regions (30) which are adjacent to first structuring separation trenches (16) or adjoin these and in particular run, at least in sections, substantially parallel to these, k) at least one third structuring step, comprising removing the layers which extend from the barrier layer (6) up to and including the front electrode layer (22) along lines spaced apart from each other, configuring third structuring separation trenches (24) which are adjacent to second structuring separation trenches (20) or adjoin these and in particular run, in sections, substantially parallel to these, I) filling the first structuring separation trenches (16) with at least one insulator material (18), m) filling the second structuring separation trenches (20) with at least one conductive material (26), n) configuring at least one conductive bridge (28) with a conductive material (26) from the second structuring separation trenches (20) filled with conductive material or the first linear conductive ranges (30) to adjacent first structuring separation trenches (16) filled with the insulator material (18) to the front electrode layer (22) of the solar cell (200) adjacent hereto, so that adjacent solar cells (200,100) are electrically connected in series.

24. The method for producing a thin-film solar module (1) according to any one of Claims 2 to 22, comprising: a) supplying an in particular planar substrate layer (2), b) applying at least one rear electrode layer (4), in particular to the substrate layer (2), c) applying at least one conductive barrier layer (6), in particular to the substrate layer (2) or to the rear electrode layer (4) or to the substrate layer (2) and to the rear electrode layer (4), in particular to the rear electrode layer (4) which has been directly applied to the substrate layer (2), d) applying at least one, in particular ohmic, contact layer (8), in particular to the barrier layer (6), e) applying at least one, in particular kesterite or chalcopyrite, semiconductor absorber layer (10), in particular to the contact layer (8), h) applying at least one transparent front electrode layer (22), in particular to the semiconductor absorber layer (10) or to the first (12) or second buffer layer (14), i) at least one first structuring step, comprising removing the layers applied to the substrate layer (2) along lines spaced apart from each other by means of laser treatment (first laser treatment), configuring first structuring separation trenches (16) which separate adjacent solar cells (100, 200), o) at least one fourth structuring step, comprising removing those layers which extend from the barrier layer (6) up to and including the front electrode layer (22) along lines spaced apart from each other, configuring fourth structuring separation trenches (20') which are adjacent to first structuring separation trenches (16) or adjoin these and, in particular, run at least in sections substantially parallel to these, p) filling the first structuring separation trenches (16) with at least one insulator material (18), q) filling a first volume region (32) of the fourth structuring separation trench (20') which extends from the barrier layer (6) up to the front electrode layer (22) along the separation trench wall (36) adjacent to the first structuring separation trench (16) with at least one conductive material (26), not filling/leaving free a second volume region (34) adjacent hereto which extends from the barrier layer (6) up to the front electrode layer (22) along that separation trench wall (38) which is not adjacent to the first structuring separation trench (16), r), configuring at least one conductive bridge (28) with a conductive material (26) from the first volume regions (32) filled with conductive material (26) of the fourth structuring separation trenches (20') to adjacent first (16) structuring separation trenches filled with the insulator material (18) to the front electrode layer (22) of the solar cell (200) adjacent hereto, so that adjacent solar cells are electrically connected in series.

25. The method according to Claim 23, **characterized in that** the steps m) and n) are combined to form a step s).

26. The method according to Claim 23 or 25, **characterized in that** the order of the steps i), j1), k), I) and m) is arbitrary, as long as I) comes directly or indirectly after i), and m) comes directly or indirectly after j1), in particular the sequence comprises i), j1), I), k), m) and n) or i), j1), I), k) and s), or that the order of the steps i), j2), k) and I) is arbitrary, as long as I) comes directly or indirectly after i), in particular the sequence comprises i), j2), I), k) and n).

27. The method according to Claim 24, **characterized in that** the steps q) and r) are combined to form a step t).

28. The method according to Claim 24 or 27, **characterized in that** the order of the steps i), o), p) and q) is arbitrary, as long as p) comes directly or indirectly after i) and q) comes directly or indirectly after o), in particular the sequence comprises i), o), p), q) and r) or i), o), p) and t).

29. The method according to any one of Claims 23 to 28, **characterized in that** the substrate (2) is permeable, at least in certain areas, to electromagnetic radiation of the first laser treatment, and/or the laser treatment of the first structuring step, in particular by means of laser ablation, is carried out from the side facing away from the coated side of the substrate (2).

30. The method according to any one of Claims 23 to 29, **characterized in that** in the second and/or third and/or fourth, in particular the second, structuring step, the second (20), third (24) or respectively fourth (20') structuring separation trenches are produced by means of laser treatment (second, third or respectively fourth laser treatment) and/or in the second and/or third and/or fourth, in particular the third and/or fourth, structuring step, the second (20), third (24) or respectively fourth (20') structuring separation trenches are produced mechanically, in particular by means of needle scribing.

31. The method according to any one of Claims 23 to 30, **characterized in that** the first (16), second (20), third (24) and/or fourth (20') structuring separation trenches and/or the first linear conductive regions (30) are produced at least in sections, in particular completely, with an average width of not more than 50 µm, in particular of not more than 30 µm and preferably of not more than 15 µm.

32. The method according to any one of Claims 23 to 31, **characterized in that**, in particular adjacent, first (16) and second (20) and/or, in particular adjacent, first (16) and third (24) and/or, in particular adjacent, second (20) and third (24) structuring separation trenches or, in particular adjacent, first (16), second (20) and third (24) structuring separation trenches or, in particular adjacent, first (16) and fourth (20') structuring separation trenches or, in particular adjacent, first structuring separation trenches (16) and first linear conductive regions (30) are routed, at least in sections, substantially parallel.

33. The method according to any one of Claims 23 to 32, **characterized in that** adjacent first structuring separation trenches (16) and/or adjacent second structuring separation trenches (20) and/or adjacent third structuring separation trenches (24) and/or adjacent fourth structuring separation trenches (20') and/or adjacent first linear conductive regions (30) are produced, at least in sections, at an average distance of in the range of 3 mm to 10 mm, in particular of 4 mm to 8 mm.

34. The method according to any one of Claims 23 to 33, **characterized in that** adjacent first (16) and second (20) structuring separation trenches and/or adjacent second (20) and third (24) structuring separation trenches and/or adjacent first (16) and fourth (20') structuring separation trenches and/or adjacent first structuring separation trenches (16) and first linear conductive regions (30) are produced, at least in sections, in particular completely, at an average distance in the range of 5 µm to 100 µm, in particular in the range of 10 µm to 50 µm.

35. The method according to any one of Claims 23 to 34, **characterized in that** adjacent first (16), second (20) and third (24) or adjacent first (16) and fourth (20') structuring separation trenches or adjacent first structuring separation trenches (16) and first linear conductive regions (30) have a smaller average distance from one another than first (16), second (20) and third (24) structuring separation trenches which are not adjacent, or respectively first (16) and fourth structuring separation trenches (20') which are adjacent, or first structuring separation trenches (16) and first linear conductive regions (30) which are not adjacent.

36. The method according to any one of Claims 23 to 35, **characterized in that** third structuring separation trenches (24), in particular all of the third structuring separation trenches (24), are separated by means of the respectively adjacent second structuring separation trench (20) or the first linear conductive region (30) from the respectively adjacent first structuring separation trench (16).

37. The method according to any one of Claims 23 to 36, **characterized in that** the contact layer (8) containing in particular at least one dopant contains or is substantially formed from molybdenum, tantalum, zirconium, cobalt, niobium and/or tungsten (first metal layer) and/or at least one metal chalcogenide selected from metal selenium imide, metal sulfide and/or metal sulfoselenide, where the metal = Mo, W, Ta, Zr, Co or niobium, in particular selected from the group consisting of MoSe₂, WSe₂, MoS₂, WS₂, Mo(Se₁₋ₓ,Sx)₂ and/or W(Se₁₋ₓ,Sx)₂, wherein x assumes values from 0 to 1.

38. The method according to any one of Claims 23 to 37, **characterized in that** the semiconductor absorber layer (10) constitutes or comprises a quaternary IB-IIIA-VIA chalcopyrite layer, in particular a Cu(ln,Ga)Se₂ layer, a penternary IB-IIIA-VIA chalcopyrite layer, in particular a Cu(ln,Ga)(Se₁₋ₓ,Sx)₂ layer, or a kesterite layer, in particular a Cu₂ZnSn(Seₓ, S₁₋ₓ)₄ layer, e.g. a Cu₂ZnSn(Se)₄ or a Cu₂ZnSn(S)₄ layer, wherein x assumes values from 0 to 1.

39. The method according to any one of Claims 23 to 38, **characterized in that** by means of the application of the kesterite or chalcopyrite semiconductor absorber layer (10) to the contact layer (8), metals present in the contact layer or metals forming this contact layer are completely or partially transformed into metal selenides, metal sulfides and/or metal sulfoselenides.

40. The method according to any one of Claims 23 to 39, **characterized in that** the first laser treatment, the second laser treatment and/or the third laser treatment are carried out with laser light pulses having a pulse duration in the range of 1 picosecond to 1 nanosecond.

41. The method according to any one of Claims 23 to 40, **characterized in that** the first, second and third structuring step or the first and fourth structuring step lead to or contribute to a monolithically integrated series connection of the solar cells (100, 200), and are in particular configured as linear processing steps.

42. The method according to any one of Claims 23 to 41, **characterized in that** the step of applying the semiconductor absorber layer (10), in particular the kesterite or chalcopyrite semiconductor absorber layer, comprises: the deposition of in particular all of the metallic components of the semiconductor absorber layer, in particular of copper, indium and, if necessary, gallium for the chalcopyrite semiconductor absorber layer and copper, zinc and tin for the kesterite semiconductor absorber layer, on the contact layer, configuring a second metal layer and the treatment of this second metal layer with selenium and/or a selenium compound as well as, if necessary, with sulfur and/or a sulfur compound.

43. The method according to any one of Claims 23 to 42, further comprising between steps e) and h) the following steps f) and/or g), in particular in this order: f) applying at least one first buffer layer (12), in particular to the semiconductor absorber layer (10), g) applying at least one second buffer layer (14), in particular to the first buffer layer (12) or the semiconductor absorber layer (10), in particular wherein in step h) the at least one transparent front electrode layer (22) is applied to the semiconductor absorber layer (10) or to the first (12) or second (14) buffer layer.

44. The method according to any one of Claims 23 to 43, **characterized in that** the rear electrode layer (4), the conductive barrier layer (6), the first metal layer, in particular containing Mo, the contact layer (8), the second metal layer, in particular containing Cu, In and Ga, the first buffer layer (12), the second buffer layer (14) and/or the front electrode layer (22) are obtained by means of physical gas phase deposition, in particular comprising physical vapor deposition (PVD) coating, vapor deposition by means of an electron beam evaporator, vapor deposition by means of a resistance evaporator, induction evaporation, ARC vapor deposition and/or cathode sputtering (sputter coating), in particular DC or RF magnetron sputtering, each preferably in a high vacuum, or by means of chemical gas phase deposition, in particular comprising chemical vapor deposition (CVD), low-pressure CVD and/or atmospheric pressure CVD.

45. The method according to any one of Claims 23 to 44, **characterized in that** the application of the rear electrode layer (4) of the conductive barrier layer (6), the first metal layer or the contact layer (8) and the second metal layer are carried out in a single vacuum coating plant, preferably using the continuous sputtering method.

46. The method according to any one of Claims 23 to 45, **characterized in that** the first and the second structuring step and the step of filling the first separation trench (16) with the insulator material (18) is carried out in a single plant.

47. The method according to any one of Claims 23 to 46, **characterized in that** the filling of the first separation trench (16) with the insulator material (18) and/or the filling of the second structuring separation trench (20) or of the first volume region (32) of the fourth structuring separation trench (20') is carried out with the conductive material (26) using the inkjet method or using the aerosol jet method.

## Revendications

1. Module solaire en couches minces photovoltaïques (1), comprenant, dans cet ordre, au moins une couche de substrat (2), au moins une couche d'électrode arrière (4), en particulier directement adjacente à la couche de substrat, au moins une couche barrière conductrice (6), en particulier directement adjacente à la couche d'électrode arrière (4), au moins une couche de contact (8), en particulier une couche de contact ohmique, en particulier directement adjacente à la couche barrière (6), au moins une couche d'absorption semi-conductrice (10), en particulier une couche d'absorption semi-conductrice de chalcopyrite ou de kësterite, en particulier directement adjacente à la couche de contact (8), au moins une couche d'électrode avant transparente (22), en particulier contenant du, ou essentiellement en, oxyde de zinc dopé n (22), **caractérisé par** des premières tranchées de séparation de structuration (16) espacées remplies avec au moins un matériau isolant (18), lesquelles séparent les unes des autres des cellules solaires (100, 200) voisines jusqu'à la couche de substrat (2), des deuxièmes tranchées de séparation de structuration (20) espacées munies d'au moins un matériau conducteur (26), lesquelles s'étendent jusqu'à la couche barrière (6) et sont respectivement voisines d'une première tranchée de séparation de structuration remplie, des troisièmes tranchées de séparation de structuration (24) espacées, lesquelles s'étendent jusqu'à la couche barrière (6) et sont respectivement voisines d'une deuxième tranchée de séparation de structuration (20), au-delà de la première tranchée de séparation de structuration (16), de laquelle la deuxième tranchée de séparation de structuration (20) est voisine, et au moins un pont conducteur (28) des deuxièmes tranchées de séparation de structuration (20) munies d'un matériau conducteur (30), par-dessus des premières tranchées de séparation de structuration (16) voisines remplies avec le matériau isolant (18) jusqu'à la couche d'électrode avant (22) de la cellule solaire (200) en étant voisine.

2. Module solaire en couches minces photovoltaïques (1), comprenant dans cet ordre au moins une couche de substrat (2), au moins une couche d'électrode arrière (4), en particulier directement adjacente à la couche de substrat (2), au moins une couche barrière conductrice (4), en particulier directement adjacente à la couche d'électrode arrière (4), au moins une couche de contact (8), en particulier une couche de contact ohmique, en particulier directement adjacente à la couche barrière (6), au moins une couche d'absorption semi-conductrice (10), en particulier une couche d'absorption semi-conductrice de chalcopyrite ou de kësterite, en particulier directement adjacente à la couche de contact (8), et au moins une couche d'électrode avant transparente (22), en particulier contenant du, ou essentiellement en, oxyde de zinc dopé n, **caractérisé par** des premières tranchées de séparation de structuration (16) espacées remplies avec au moins un matériau isolant (18), lesquelles séparent les unes des autres des cellules solaires (100, 200) voisines jusqu'à la couche de substrat (2), des quatrièmes tranchées de séparation de structuration (20') espacées, lesquelles s'étendent jusqu'à la couche barrière (6) et sont respectivement voisines d'une première tranchée de séparation de structuration (16) remplie, et lesquelles comprennent une première zone de volume (32), laquelle s'étend de la couche barrière (6) jusqu'à la couche d'électrode avant (22) le long de la paroi de tranchée de séparation (36) voisine de la première tranchée de séparation de structuration (16) et laquelle est munie d'au moins un matériau conducteur (26), et une deuxième zone de volume (34) en étant voisine, laquelle s'étend de la couche de barrière (6) jusqu'à la couche d'électrode avant (22), et au moins un pont conducteur (28) des premières zones de volume (32) des quatrièmes tranchées de séparation de structuration (20'), remplies par un matériau conducteur (26) ou munies d'un tel matériau, par-dessus des premières tranchées de séparation de structuration (16) voisines, remplies avec un matériau isolant (18), jusqu'à la couche d'électrode avant (22) de la cellule solaire (200) en étant voisine.

3. Module solaire en couches minces (1) selon la revendication 1 ou 2, **caractérisé en ce que** la couche d'absorption semi-conductrice (10) représente ou comprend une couche de chalcopyrite IB-IIIA-VIA quaternaire, en particulier une couche de Cu(ln,Ga)Se2, une couche de chalcopyrite IB-IIIA-VIA quinternaire, en particulier une couche de Cu(ln,Ga)(Se1-x,Sx)2, ou une couche de kësterite, en particulier une couche de Cu2ZnSn(Sex,S1-x)4, par exemple une couche de Cu2ZnSn(Se)4 ou une couche de Cu2ZnSn(S)4, x prenant des valeurs de 0 à 1.

4. Module solaire en couches minces (1) selon l'une quelconque des revendications précédentes, **caractérisé en ce que** le substrat (2) représente une plaque de verre, une plaque de plastique ou une plaque de métal, en particulier avec une largeur supérieure à 0,5 m, en particulier supérieure à 2,0 m, et une longueur supérieure à 1,2 m, en particulier supérieure à 3,0 m.

5. Module solaire en couches minces (1) selon l'une quelconque des revendications précédentes, **caractérisé en ce que** la couche d'électrode arrière (4) comprend du, ou est essentiellement formée de, V, Mn, Cr, Mo, Ti, Co, Zr, Ta, Nb et/ou W et/ou comprend, et/ou est essentiellement formée d'un alliage comprenant du V, Mn, Cr, Mo, Ti, Co, Fe, Ni, Al, Zr, Ta, Nb et/ou W.

6. Module solaire en couches minces (1) selon l'une quelconque des revendications précédentes, **caractérisé en ce que** la couche barrière (6) représente une barrière pour des composants, en particulier diffusants ou diffusibles, migrant à partir de et/ou par la couche d'électrode arrière (4) et/ou pour des composants, en particulier diffusants ou diffusibles, migrant à partir de et/ou par la couche de contact, en particulier une couche barrière bidirectionnelle.

7. Module solaire en couches minces (1) selon l'une quelconque des revendications précédentes, **caractérisé en ce que** la couche barrière (6) représente une barrière pour des ions alcalins, en particulier des ions sodium, ou des composés comprenant des ions alcalins, du sélénium ou des composés de sélénium, du soufre ou des composés de soufre et/ou des métaux, en particulier Cu, In, Ga, Fe, Ni, Ti, Zr, Hf, V, Nb, Ta, Al et/ou W.

8. Module solaire en couches minces (1) selon l'une quelconque des revendications précédentes, **caractérisé en ce que** la couche barrière (6) comprend, ou est essentiellement formée de, au moins un nitrure métallique, en particulier TiN, MoN, TaN, ZrN et/ou WN, au moins un carbure métallique, au moins un borure métallique et/ou au moins un nitrure de silicium métallique, en particulier TiSiN, TaSiN et/ou WSiN.

9. Module solaire en couches minces (1) selon l'une quelconque des revendications précédentes, **caractérisé en ce que** la couche de contact (8) comprend du, ou est essentiellement formée de, Mo, W, Ta, Nb, Zr et/ou Co, en particulier Mo et/ou W, et/ou comprend au moins un chalcogénure de métal ou en est essentiellement formée, et/ou au moins une première couche voisine de la couche barrière (6), comprenant du, ou essentiellement en, Mo, W, Ta, Nb, Zr et/ou Co, en particulier Mo et/ou W, et au moins une deuxième couche, non voisine de la couche barrière (6), comprenant, ou essentiellement en, au moins un chalcogénure de métal.

10. Module solaire en couches minces (1) selon la revendication 9, **caractérisé en ce que** le métal du chalcogénure de métal de la couche de contact (8) ou de la deuxième couche de la couche de contact est sélectionné parmi le groupe se composant de molybdène, tungstène, tantale, zirconium, cobalt et/ou niobium, et **en ce que** le chalcogène du chalcogénure de métal est sélectionné parmi le groupe se composant de sélénium et/ou soufre, le chalcogénure de métal représentant en particulier MSe2, MS2 et/ou M(Se1 -x,Sx)2, avec M = Mo, W, Ta, Zr, Co ou Nb, x prenant des valeurs de 0 à 1.

11. Module solaire en couches minces (1) selon l'une quelconque des revendications 9 ou 10, **caractérisé en ce que** le métal de la première couche et le métal de la deuxième couche de la couche de contact (8) correspondent et/ou **en ce que** le métal de la première couche et/ou le métal de la deuxième couche de la couche de contact (8) correspondent au métal de la couche d'électrode arrière (4) et/ou **en ce que** le métal de la couche de contact (8) correspond au métal de la couche d'électrode arrière (4).

12. Module solaire en couches minces (1) selon l'une quelconque des revendications précédentes, **caractérisé en ce que** la couche d'absorption semi-conductrice (10) présente au moins un dopant, en particulier au moins un élément sélectionné parmi le groupe se composant de sodium, potassium et lithium et/ou au moins un composé de ces éléments, de préférence avec de l'oxygène, du sélénium, du soufre, du bore et/ou des halogènes, par exemple iode ou fluor, et/ou au moins un bronze de métal alcalin, en particulier du bronze de sodium et/ou du bronze de potassium, de préférence avec un métal sélectionné parmi le groupe se composant de molybdène, tungstène, tantale et/ou niobium.

13. Module solaire en couches minces (1) selon la revendication 12, **caractérisé en ce que** le dopant, en particulier des ions sodium, est présent dans la couche de contact et/ou dans la couche absorbante semi-conductrice à une teneur dans la plage de 1 013 à 1 017 atomes/cm2, en particulier dans la plage de 1 014 à 1 016 atomes/cm2.

14. Module solaire en couches minces photovoltaïques (1) selon l'une quelconque des revendications précédentes, comprenant en outre au moins une première couche tampon, en particulier directement adjacente à la couche absorbante semi-conductrice (10), comprenant du, ou constituée essentiellement de, CdS ou d'une couche sans CdS, en particulier comprenant du, ou constituée essentiellement de, Zn(S,OH) ou In2S3, et/ou au moins d'une deuxième couche tampon (14), en particulier immédiatement adjacente à la couche absorbante semi-conductrice (10) ou à la première couche tampon (12), comprenant du, et constituée essentiellement de, oxyde de zinc intrinsèque et/ou oxyde de zinc à haute résistance, la couche d'électrode avant transparente (22) étant en particulier directement adjacente à la couche absorbante semi-conductrice (10), à la première couche tampon (12) et/ou à la deuxième couche tampon (14).

15. Module solaire en couches minces (1) selon l'une quelconque des revendications précédentes, **caractérisé en ce que** l'épaisseur moyenne de la couche d'électrode arrière (4) se trouve dans la plage de 50 nm à 500 nm, en particulier dans la plage de 80 nm à 250 nm, et/ou celle de la couche barrière (6) dans la plage de 10 nm à 250 nm, en particulier dans la plage de 20 nm à 150 nm, et/ou celle de la couche de contact (8) dans la plage de 2 nm à 200 nm, en particulier dans la plage de 5 nm à 100 nm, et/ou celle de la couche absorbante semi-conductrice (10) dans la plage de 400 nm à 2 500 nm, en particulier dans la plage de 500 nm à 2 000 nm et de préférence dans la plage de 800 nm à 1 600 nm, et/ou celle de la première couche tampon (12) dans la plage de 5 nm à 100 nm, en particulier dans la plage de 10 nm à 70 nm, et/ou celle de la deuxième couche tampon (14) dans la plage de 10 nm à 150 nm, en particulier dans la plage de 20 nm à 100 nm

16. Module solaire en couches minces (1) selon l'une quelconque des revendications précédentes, **caractérisé en ce que** la couche de d'électrode arrière (4) comprend du molybdène et/ou du tungstène, en particulier du molybdène, ou est essentiellement formée de molybdène et/ou de tungstène, en particulier de molybdène, **en ce que** la couche barrière conductrice (6) comprend du TiN ou est essentiellement formée de TiN, et **en ce que** la couche de contact (8) comprend du MoSe2 ou est formée essentiellement de MoSe2.

17. Module solaire en couches minces (1) selon l'une quelconque des revendications précédentes, **caractérisé en ce que** les premières (16), deuxièmes (20), troisièmes (24) et/ou quatrièmes (20') tranchées de séparation de structuration présentent, au moins par sections, en particulier totalement, une largeur moyenne ne dépassant pas 50 µm, en particulier ne dépassant pas 30 µm et de préférence ne dépassant pas 15 µm.

18. Module solaire en couches minces (1) selon l'une quelconque des revendications précédentes, **caractérisé en ce que** des premières (16) et deuxièmes (20) tranchées de séparation de structuration, en particulier voisines, et/ou des premières (16) et troisièmes (24) tranchées de séparation de structuration, en particulier voisines, et/ou des deuxièmes (20) et troisièmes (24) tranchées de séparation de structuration, en particulier voisines, ou des premières (16), deuxièmes (20) et troisièmes (24) tranchées de séparation de structuration, en particulier voisines, ou des premières (16) et quatrièmes (20') tranchées de séparation de structuration, en particulier voisines, s'étendent essentiellement de façon parallèle, au moins par sections.

19. Module solaire en couches minces (1) selon l'une quelconque des revendications précédentes, **caractérisé en ce que** des premières tranchées de séparation de structuration (16) voisines et/ou des deuxièmes tranchées de séparation de structuration (20) voisines, et/ou des troisièmes tranchées de séparation de structuration (24) voisines, et/ou des quatrièmes tranchées de séparation de structuration (20') voisines présentent, au moins par sections, une distance moyenne dans la plage de 3 mm à 10 mm, en particulier de 4 mm à 8 mm.

20. Module solaire en couches minces (1) selon l'une quelconque des revendications précédentes, **caractérisé en ce que** des premières (16) et des deuxièmes (20) tranchées de séparation de structuration voisines, et/ou des deuxièmes (20) et des troisièmes (24) tranchées de séparation de structuration voisines, et/ou des premières (16) et des quatrièmes (20') tranchées de séparation de structuration voisines présentent, au moins par sections, en particulier totalement, une distance moyenne dans la plage de 5 µm à 100 µm, en particulier dans la plage de 10 µm à 50 µm.

21. Module solaire en couches minces (1) selon l'une quelconque des revendications précédentes, **caractérisé en ce que** les premières tranchées de séparation de structuration (16) sont remplies avec l'isolant (18) au-dessus du niveau de la couche de contact (8), en particulier au-dessus du niveau de la couche absorbante semi-conductrice, et/ou en ce que la résistance de pont au-dessus de la première tranchée de séparation de structuration (16) remplie avec l'isolant (18) est supérieure à 50 kOhm, en particulier supérieure à 100 kOhm.

22. Module solaire en couches minces selon l'une quelconque des revendications précédentes, **caractérisé par** au moins deux, en particulier une multiplicité, de cellules solaires connectées en série par intégration monolithique.

23. Procédé pour la fabrication d'un module solaire en couches minces (1) selon l'une des revendications 1 et 3 à 22, pour autant que celles-ci se rapportent directement ou indirectement à la revendication 1, comprenant : a) la mise à disposition d'une couche de substrat (2), en particulier plane, b) l'application d'au moins une couche d'électrode arrière (4), en particulier sur la couche de substrat (2), c) l'application d'au moins une couche barrière conductrice (6), en particulier sur la couche d'électrode arrière (4) ou sur la couche de substrat (2) et sur la couche d'électrode arrière (4), en particulier sur la couche d'électrode arrière (4), laquelle a été appliquée directement sur la couche de substrat (2), d) l'application d'au moins une couche de contact (8), en particulier ohmique, en particulier sur la couche barrière (6), e) l'application d'au moins une couche absorbante semi-conductrice (10), en particulier de kësterite ou de chalcopyrite, en particulier sur la couche de contact (8) h) l'application d'au moins une couche d'électrode avant transparente (22), en particulier sur la couche absorbante semi-conductrice (10) ou sur la première (12) ou la deuxième (14) couche tampon, i) au moins une première étape de structuration, comprenant l'enlèvement des couches (4, 6, 8, 10, 12, 14, 22) appliquées sur la couche de substrat (2) le long de lignes espacées les unes des autres au moyen d'un traitement au laser (premier traitement au laser) avec formation de premières tranchées de séparation de structuration (16), lesquelles séparent des cellules solaires (100, 200) voisines, j) au moins une deuxième étape de structuration, comprenant j1) l'enlèvement des couches qui s'étendent de la couche barrière (6) jusqu'à la couche d'électrode avant (22) comprise, le long de lignes espacées les unes des autres avec formation de deuxièmes tranchées de séparation de structuration (20), lesquelles sont voisines des premières tranchées de séparation de structuration (16) ou sont adjacentes à celles-ci et, en particulier, s'étendent essentiellement de façon parallèle à celles-ci au moins par sections, ou j2) la transformation de phase chimique et/ou thermique des couches qui s'étendent de la couche barrière (6) jusqu'à la couche d'électrode avant (22) comprise, le long de lignes espacées les unes des autres avec formation de premières zone conductrices linéaires (30), lesquelles sont voisines des premières tranchées de séparation de structuration (16) ou sont adjacentes à celles-ci et, en particulier, s'étendent essentiellement de façon parallèle à celles-ci, au moins par sections, k) au moins une troisième étape de structuration, comprenant l'enlèvement des couches s'étendant de la couche barrière (6) jusqu'à la couche d'électrode avant (22) comprise, le long de lignes espacées les unes des autres avec formation de troisièmes tranchées de séparation de structuration (24), lesquelles sont voisines de deuxièmes tranchées de séparation de structuration (20) ou sont adjacentes à celles-ci et s'étendent essentiellement de façon parallèle à celles-ci, en particulier par sections, l) le remplissage des premières tranchées de séparation de structuration (16) avec au moins un matériau isolant (18), m) le remplissage des deuxièmes tranchées de séparation de structuration (20) avec au moins un matériau conducteur (26), n) la formation d'au moins un pont conducteur (28) avec un matériau conducteur (26) des deuxièmes tranchées de séparation de structuration (20) remplies avec du matériau conducteur ou des premières zones conductrices en formes de lignes (30), par-dessus des premières tranchées de séparation de structuration (16) voisines remplies avec du matériau isolant (18), jusqu'à la couche d'électrode avant (22) de la cellule solaire (200) en étant voisine, de telle sorte que des cellules solaires (200, 100) voisines sont connectées électriquement en série.

24. Procédé pour la fabrication d'un module solaire en couches minces (1) selon l'une des revendications 2 à 22, comprenant : a) la mise à disposition d'une couche de substrat (2), en particulier plane, b) l'application d'au moins une couche d'électrode arrière (4), en particulier sur la couche de substrat (2), c) l'application d'au moins une couche barrière conductrice (6), en particulier sur la couche de substrat (2) ou sur la couche d'électrode arrière (4), ou sur la couche de substrat (2) et sur la couche d'électrode arrière (4), en particulier sur la couche d'électrode arrière (4), laquelle a été appliquée directement sur la couche de substrat (2), d) l'application d'au moins une couche de contact (8), en particulier ohmique, en particulier sur la couche barrière (6), e) l'application d'au moins une couche absorbante semi-conductrice (10), en particulier de kësterite ou de chalcopyrite, en particulier sur la couche de contact (8), h) l'application d'au moins une couche d'électrode avant transparente (22), en particulier sur la couche absorbante semi-conductrice (10) ou sur la première (12) ou la deuxième (14) couche tampon, i) au moins une première étape de structuration, comprenant l'enlèvement des couches appliquées sur la couche de substrat (2) le long de lignes espacées les unes des autres au moyen d'un traitement au laser (premier traitement au laser) avec formation de premières tranchées de séparation de structuration (16), lesquelles séparent des cellules solaires (100, 200) voisines, o) au moins une quatrième étape de structuration, comprenant l'enlèvement des couches s'étendant de la couche barrière (6) jusqu'à la couche d'électrode avant (22) comprise, le long de lignes espacées les unes des autres avec formation de quatrièmes tranchées de séparation de structuration (20'), lesquelles sont voisines des premières tranchées de séparation de structuration (16) ou sont adjacentes à celles-ci et, en particulier, s'étendent essentiellement de façon parallèle à celles-ci, au moins par sections, p) le remplissage des premières tranchées de séparation de structuration (16) avec au moins un matériau isolant (18), q) le remplissage d'une première zone de volume (32) des quatrièmes tranchées de séparation de structuration (20'), laquelle s'étend de la couche barrière (6) jusqu'à la couche d'électrode avant (22), le long de la paroi de tranchée de séparation (36) voisine de la première tranchée de séparation de structuration (16) avec au moins un matériau isolant (26), avec non remplissage de/en laissant libre une deuxième zone de volume (34) en étant voisine, laquelle s'étend de la couche barrière (6) jusqu'à la couche d'électrode avant (22) le long de la paroi de tranchée de séparation (38) qui n'est pas voisine de la première tranchée de séparation de structuration (16), r) la formation d'au moins un pont conducteur (28) avec un matériau conducteur (26) de la première zone de volume (32) des quatrièmes tranchées de séparation de structuration (20') remplie avec du matériau conducteur (26), par-dessus des premières tranchées de séparation de structuration (16) voisines remplies avec du matériau isolant (18), jusqu'à la couche d'électrode avant (22) de la cellule solaire (200) en étant voisine, de telle sorte que des cellules solaires voisines sont connectées électriquement en série.

25. Procédé selon la revendication 23, **caractérisé en ce que** les étapes m) et n) sont réunies en une étape s).

26. Procédé selon la revendication 23 ou 25, **caractérisé en ce que** l'ordre des étapes i), j1), k), l) et m) est quelconque, tant que l) est effectuée après i), indirectement ou directement, et que m) est effectuée après j1), indirectement ou directement, en particulier comprend la séquence i), j1), l), k), m) et n) ou i), j1, l), k) et s), ou **en ce que** l'ordre des étapes i), j2), k) et l) est quelconque, tant que l) est effectuée après i), indirectement ou directement, en particulier comprend la séquence i), j2), l), k) et n).

27. Procédé selon la revendication 24, **caractérisé en ce que** les étapes q) et r) sont réunies en une étape t).

28. Procédé selon la revendication 24 ou 27, **caractérisé en ce que** l'ordre des étapes i), o), p) et q) est quelconque, tant que p) est effectuée après i), indirectement ou directement, et que q) est effectuée après o), indirectement ou directement, en particulier comprend la séquence i), o), p), q) et r) ou i), o), p) et t).

29. Procédé selon l'une des revendications 23 à 28, **caractérisé en ce que**
le substrat (2) est perméable au rayonnement électromagnétique du premier traitement au laser, au moins par zones, et/ou **en ce que** le traitement au laser de la première étape de structuration est effectué du côté opposé au côté revêtu du substrat (2), en particulier par ablation par laser.

30. Procédé selon l'une des revendications 23 à 29, **caractérisé en ce que**, lors de la deuxième et/ou de la troisième et/ou de la quatrième étape de structuration, en particulier de la deuxième, les deuxièmes (20), troisièmes (24) ou quatrièmes (20') tranchées de séparation de saturation sont produites au moyen d'un traitement au laser (deuxième, troisième ou quatrième traitement au laser) et/ou **en ce, que** lors de la deuxième et/ou troisième et/ou quatrième étape de structuration, en particulier de la troisième et/ou de la quatrième, les deuxièmes (20), troisièmes (24) ou quatrièmes (20') tranchées de séparation de structuration sont produites de façon mécanique, en particulier par gravure à l'aiguille.

31. Procédé selon l'une des revendications 23 à 30, **caractérisé en ce que** les premières (16), deuxièmes (20), troisièmes (24) et/ou quatrièmes (20') tranchées de séparation de structuration et/ou les premières zones conductrices linéaires (30) sont produites, au moins par sections, en particulier totalement, avec une largeur moyenne ne dépassant pas 50 µm, en particulier ne dépassant pas 30 µm et de préférence ne dépassant pas 15 µm.

32. Procédé selon l'une des revendications 23 à 31, **caractérisé en ce que** des premières (16) et deuxièmes (20) tranchées de séparation de structuration, en particulier voisines, et/ou des premières (16) et troisièmes (24) tranchées de séparation de structuration, en particulier voisines, des deuxièmes (20) et troisièmes (24) tranchées de séparation de structuration, en particulier voisines, ou des premières (16), deuxièmes (20) et troisièmes (24) tranchées de séparation de structuration, en particulier voisines, ou des premières (16) et quatrièmes (20') tranchées de séparation de structuration, en particulier voisines, ou de premières tranchées de séparation de structuration (16) et de premières zones conductrices linéaires (30), en particulier voisines, s'étendent essentiellement de façon parallèle, au moins par sections.

33. Procédé selon l'une des revendications 23 à 32, **caractérisé en ce que** des premières tranchées de séparation de structuration (16) voisines et/ou des deuxièmes tranchées de séparation de structuration (20) voisines, et/ou des troisièmes tranchées de séparation de structuration (24) voisines, et/ou des quatrièmes tranchées de séparation de structuration (20') voisines et/ou de premières zones conductrices linéaires (30) voisines sont produites, au moins par sections, avec une distance moyenne dans la plage de 3 mm à 10 mm, en particulier de 4 mm à 8 mm.

34. Procédé selon l'une des revendications 23 à 33, **caractérisé en ce que** des premières (16) et deuxièmes (20) tranchées de séparation de structuration voisines et/ou des deuxièmes (20) et troisièmes (24) tranchées de séparation de structuration voisines, et/ou des premières (16) et quatrièmes (20') tranchées de séparation de structuration voisines, et/ou des premières tranchées de séparation de structuration (16) voisines et des premières zones conductrices linéaires (30) voisines sont produites, au moins par sections, en particulier totalement, avec une distance moyenne dans la plage de 5 µm à 100 µm, en particulier dans la plage de 10 µm à 50 µm.

35. Procédé selon l'une des revendications 23 à 34, **caractérisé en ce que** des premières (16), deuxièmes (20) et troisièmes (24) tranchées de séparation de structuration voisines ou des premières (16) et quatrièmes (20') tranchées de séparation de structuration voisines ou des premières tranchées de séparation de structuration (16) et des premières zones conductrices linéaires (30) voisines présentent une distance moyenne entre elles plus faibles que des premières (16), deuxièmes (20) et troisièmes (24) tranchées de séparation de structuration non voisines ou que des premières (16) et quatrièmes (20') tranchées de séparation de structuration non voisines ou que des premières tranchées de séparation de structuration (16) et des premières zones conductrices linéaires (30) non voisines.

36. Procédé selon l'une des revendications 23 à 35, **caractérisé en ce que** des troisièmes tranchées de séparation de structuration (24), en particulier toutes les troisièmes tranchées de séparation de structuration (24) sont séparées de la première tranchée de séparation de structuration (16) respectivement voisine par la deuxième tranchée de séparation de structuration (20) respectivement voisine ou par la première zone conductrice linéaire (30).

37. Procédé selon l'une des revendications 23 à 36, **caractérisé en ce que** la couche de contact (8) comprenant au moins un dopant comprend du, ou est essentiellement formée de, molybdène, tantale, zirconium, cobalt, niobium et/ou tungstène (première couche métallique) et/ou d'au moins un chalcogénure de métal sélectionné parmi le groupe se composant de séléniure métallique, sulfure métallique et/ou sulfo-séléniure métallique, avec métal = Mo, W, Ta, Zr, Co ou Nb, en particulier sélectionné parmi le groupe se composant de MoSe2, WSe2, MoS2, WS2, Mo(Se1-x,Sx) 2 et/ou W(Se1-x,Sx) 2, x prenant des valeurs de 0 à 1.

38. Procédé selon l'une des revendications 23 à 37, **caractérisé en ce que** la couche d'absorption semi-conductrice (10) représente ou comprend une couche de chalcopyrite IB-IIIA-VIA quaternaire, en particulier une couche de Cu(ln,Ga)Se2, une couche de chalcopyrite IB-IIIA-VIA quinternaire, en particulier une couche de Cu(ln,Ga)(Se1-x,Sx)2, ou une couche de kësterite, en particulier une couche de Cu2ZnSn(Sex,S1-x)4, par exemple une couche de Cu2ZnSn(Se)4 ou une couche de Cu2ZnSn(S)4, x prenant des valeurs de 0 à 1.

39. Procédé selon l'une des revendications 23 à 38, **caractérisé en ce que** des métaux présents dans la couche de contact ou formant cette couche de contact sont transformés totalement ou partiellement en séléniures métalliques, sulfures métalliques et/ou sulfo-séléniures métalliques par l'application de la couche absorbante semi-conductrice (10) de kësterite ou de chalcopyrite sur la couche de contact (8).

40. Procédé selon l'une des revendications 23 à 39, **caractérisé en ce que** le premier traitement au laser, le deuxième traitement au laser et/ou le troisième traitement au laser sont effectués avec des impulsions de lumière laser avec une durée d'impulsion dans la plage de 1 picoseconde à 1 nanoseconde.

41. Procédé selon l'une des revendications 23 à 40, **caractérisé en ce que** les première, deuxième et troisième étapes de structuration ou les première et quatrième étapes de structuration réalisent une connexion en série par intégration monolithique des cellules solaires (100, 200) ou y contribuent et sont conçues en particulier comme étapes de traitement linéaires.

42. Procédé selon l'une des revendications 23 à 41, **caractérisé en ce que** l'étape de l'application de la couche absorbante semi-conductrice (10), en particulier de la couche absorbante semi-conductrice de kësterite ou de chalcopyrite, comprend : le dépôt de composants métalliques de la couche absorbante semi-conductrice, en particulier de leur totalité, en particulier de cuivre, d'indium et le cas échéant de gallium pour la couche absorbante semi-conductrice de chalcopyrite, et de cuivre, de zinc et d'étain pour la couche absorbante semi-conductrice de kësterite, sur la couche de contact avec formation d'une deuxième couche métallique et le traitement de cette deuxième couche métallique avec du sélénium et/ou un composé de sélénium ainsi que, le cas échéant, avec du soufre et/ou un composé de soufre.

43. Procédé selon l'une des revendications 23 à 42, comprenant en outre les étapes suivantes f) et/ou g) entre les étapes e) et h), en particulier dans cet ordre, f) l'application d'au moins une première couche tampon (12), en particulier sur la couche absorbante semi-conductrice (10), g) l'application d'au moins une deuxième couche tampon (14), en particulier sur la première couche tampon (12) ou sur la couche absorbante semi-conductrice (10), l'au moins une couche d'électrode avant transparente (22) étant en particulier appliquée sur la couche absorbante semi-conductrice (10) ou sur la première (12) ou la deuxième (14) couche tampon lors de l'étape h).

44. Procédé selon l'une des revendications 23 à 43, **caractérisé en ce que** la couche d'électrode arrière (4), la couche barrière conductrice (6), la première couche métallique, en particulier comprenant du Mo, la couche de contact (8), la deuxième couche métallique, en particulier contenant du Cu, de l'In et du Ga, la première couche tampon (12), la deuxième couche tampon (14) et/ou la couche d'électrode avant (22) sont obtenues par dépôt physique en phase vapeur, en particulier comprenant un revêtement par dépôt physique en phase vapeur (PVD), évaporation par système d'évaporation par faisceau d'électrons, évaporation par système d'évaporation par résistance, évaporation par induction, évaporation par arc et/ou pulvérisation cathodique (sputtering), en particulier pulvérisation magnétron DC ou RF, respectivement de préférence sous vide poussé, ou par dépôt chimique en phase vapeur, comprenant en particulier le dépôt chimique en phase vapeur (CVD), le CVD à basse pression (low pressure) et/ou le CVD à pression atmosphérique (atmospheric pressure).

45. Procédé selon l'une des revendications 23 à 44, **caractérisé en ce que** l'application de la couche d'électrode arrière (4), de la couche barrière conductrice (6), de la première couche métallique ou de la couche de contact (8) et de la deuxième couche métallique est effectuée dans une seule installation de revêtement sous vide, de préférence par procédé de pulvérisation en continu.

46. Procédé selon l'une des revendications 23 à 45, **caractérisé en ce que**
les première et deuxième étapes de structuration et l'étape de remplissage de la première tranchée de séparation de structuration (16) par le matériau isolant (18) sont effectuées dans une seule installation.

47. Procédé selon l'une des revendications 23 à 46, **caractérisé en ce que** le remplissage de la première tranchée de séparation de structuration (16) par le matériau isolant (18) et/ou le remplissage de la deuxième tranchée de séparation (20) ou de la première zone de volume (32) de la quatrième tranchée de séparation de structuration (20') par le matériau conducteur (26) sont effectués par procédé à jet d'encre ou par procédé à jet d'aérosol.
